(19) Europäisches Patentamt
European Patent Office
Office européen des brevets

(11) EP 4 541 866 A1

(12) **EUROPEAN PATENT APPLICATION**
published in accordance with Art. 153(4) EPC

(43) Date of publication:
**23.04.2025 Bulletin 2025/17**

(21) Application number: **23824001.4**

(22) Date of filing: **16.06.2023**

(51) International Patent Classification (IPC):
***C09K 5/14*** *(2006.01)* ***C08L 83/04*** *(2006.01)*
***C08L 83/05*** *(2006.01)* ***C08L 83/07*** *(2006.01)*

(52) Cooperative Patent Classification (CPC):
**C08L 83/04; C09K 5/14**

(86) International application number:
**PCT/JP2023/022400**

(87) International publication number:
**WO 2023/243711 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.06.2022 JP 2022098435**
**31.08.2022 JP 2022138189**

(71) Applicants:
- **SEKISUI CHEMICAL CO., LTD.**
**Osaka-shi**
**Osaka**
**530-8565 (JP)**
- **Sekisui Polymatech Co., Ltd.**
**Saitama-city, Saitama 338-0837 (JP)**

(72) Inventors:
- **SUDA, Hiromi**
**Saitama-city, Saitama 338-0837 (JP)**
- **IWAMOTO, Tatsuya**
**Mishima-gun, Osaka 618-0021 (JP)**

(74) Representative: **Ter Meer Steinmeister & Partner Patentanwälte mbB**
**Nymphenburger Straße 4**
**80335 München (DE)**

# (54) HEAT-CONDUCTIVE COMPOSITION AND HEAT-CONDUCTIVE MEMBER

(57) A thermally conductive composition comprising: (A) an organopolysiloxane having an alkenyl group, (B) an organopolysiloxane having a hydrosilyl group, (C) a thermally conductive filler, (D) a polysiloxane compound having a methacryloyl group, and (E) a hydrosilylation catalyst, a weight average molecular weight $M_{wd}$ of the (D) being smaller than a weight average molecular weight $M_{wa}$ of the (A).

## Description

### Technical Field

The present invention relates to a thermally conductive composition and a thermally conductive member.

### Background Art

Curable liquid types of thermally conductive compositions are widely known, and for example, are used as thermally conductive members, such as heat-dissipating gap fillers for conducting heat generated from a heating element to a heat-dissipating element, which are cured products formed by filling a curable liquid thermally conductive composition into gaps between a heating element and a heat-dissipating element, and then curing the composition. Traditionally, as such thermally conductive compositions, silicone thermally conductive compositions containing organopolysiloxane and a thermally conductive filler are widely used.

In recent market circumstances where the production quantity of electric vehicles is steadily growing, electrification for the purpose of enhancing energy efficiency and improve safety has been progressed. Regarding to in-vehicle electrical components, needs for automatic packaging are increasing, and there is an increasing demand for a liquid heat-dissipating gap filler usable in portions having complex shapes.

In recent vehicles, energy efficiency is one of important matters for differentiation, and it is demanded that the vehicle body weight is reduced as much as possible. The in-vehicle electrical components are no exception in this respect, and development for a reduction in weight and size has been progressed. However, a reduction in sizes of in-vehicle electrical components in an increase in heat quantity generated per unit volume, that is, heat generation density. For this reason, the heat-dissipating gap filler should have reliability such that it can be used for a long time without degradation in performance such as thermal conductivity.

Traditional thermally conductive compositions have been examined for reliability in various ways. For example, Patent Literature 1 discloses a thermally conductive silicone gel composition which is a cured product of components comprising: (A) an organopolysiloxane having two alkenyl groups in one molecule; (B) an organo-hydrogen polysiloxane having two Si-H groups in one molecule; (C) an organo-hydrogen polysiloxane having three or more Si-H groups in one molecule; (D) at least one compound selected from the following (D1) or (D2): (D1) an organopolysiloxane having one alkenyl group in one molecule, and (D2) an organo-hydrogen polysiloxane having one Si-H group in one molecule; (E) a platinum catalyst; and (F) a thermally conductive filler in an amount of 100 to 600 vol% relative to the total amount of the (A) to (E), which is regarded as 100 vol%.

According to Patent Literature 1, the molecular weight is controlled by the component (D) such that the molecular weight does not becomes larger, and Patent Literature 1 discloses that there can be provided a thermally conductive silicone gel composition which is a gel-like cured product and still has reduced oil bleed. However, it is assumed in Patent Literature 1 that the heat generating electronic parts such as IC packages have a surface temperature of about 80°C, while the reliability in temperatures higher than that is not mentioned.

### Citation List

#### Patent Literature

PTL 1: WO 2021/140694

### Summary of Invention

#### Technical Problem

By the way, to improve the comfort of passenger cabins in recent vehicles, a larger cabin space is required. In examination of the layout of vehicle parts, large and heavy essential parts such as engines and motors often occupy higher priority, and relatively small and light-weight parts such as electrical components have to be disposed in the remaining spaces. As a result, some of the electrical components may be exposed to a high temperature environment at 150°C or higher inside the engine room or near the motor, and accordingly, the heat-dissipating gap filler may also be used under such a high temperature in some cases. However, when the heat-dissipating gap filler formed of a traditional thermally conductive silicone thermally conductive composition is used under a high temperature environment at 150°C or more for a long time, the hardness thereof is increased, so that the heat-dissipating gap filler peels off from the heating element and/or the heat-dissipating element. Thus, it is difficult to suppress an increase in heat resistance.

For traditional thermally conductive compositions including a silicone resin containing an organopolysiloxane

having an alkenyl group and an organo-hydrogen polysiloxane having a hydrosilyl group as the main components, it is also considered that, to increase the flexibility, the density of cross-linking points is reduced by increasing the lengths of chains between cross-linking points and thus reducing the functional group concentration.

However, an increase in lengths of chains between cross-linking points leads to an increase the molecular weight of the silicone resin, resulting in high viscosity. The silicone resin having a large molecular weight has low reactivity, and is thus difficult to diffuse in a solid to which the thermally conductive composition changes from a liquid as the curing reaction progresses. For this reason, as the reaction of the silicone resin progresses, a possibility of contact between reactive groups is reduced, and finally, unreacted components remain for a long time. When unreacted components remain, these unfortunately cause a reduction in heat resistance under a high temperature environment at 150°C or more, for example. In this case, the hardness of the cured product may be increased, for example, by a reaction derived from an unreactive functional group, e.g., the cross-linking reaction between hydrosilyl groups.

The present invention has been made in consideration of such problems, and an object of the present invention is to provide a thermally conductive composition which can be formed into a thermal conductive member whose hardness is less likely to increase even under a high temperature environment at 150°C or more.

Solution to Problem

As a result of extensive research, the present inventors have found that a silicone compound having a methacryloyl group has a low addition reaction rate even if it has a smaller molecular weight than that of a silicone compound having an alkenyl group as a base agent, and that the above problems can thus be solved.

Specifically, the present invention provides [1] to [19] below.

[1] A thermally conductive composition comprising: (A) an organopolysiloxane having an alkenyl group, (B) an organo-hydrogen polysiloxane having a hydrosilyl group, (C) a thermally conductive filler, (D) a polysiloxane compound having a methacryloyl group, and (E) a hydrosilylation catalyst, a weight average molecular weight of the component (D), $M_{wd}$, being smaller than a weight average molecular weight of the component (A), $M_{wa}$.

[2] A thermally conductive composition comprising: (A) an organopolysiloxane having an alkenyl group, (B) an organo-hydrogen polysiloxane having a hydrosilyl group, (C) a thermally conductive filler, (D) a polysiloxane compound having a methacryloyl group, and (E) a hydrosilylation catalyst, the thermally conductive composition being a combination of a first agent containing at least one of the component (A) or the component (D); and the component (E) but not containing the component (B), and a second agent containing the component (B) but not containing the component (E), the component (C) being contained in at least one of the first agent or the second agent, and a weight average molecular weight of the component (D), $M_{wd}$, being smaller than a weight average molecular weight of the component (A), $M_{wa}$.

[3] The thermally conductive composition according to [1] or [2], wherein the weight average molecular weight $M_{wd}$ of the component (D) and the weight average molecular weight $M_{wa}$ of the component (A) satisfy Expression (1) below:

$$M_{wd}\times 2.3\leq M_{wa}\ ...(1).$$

[4] The thermally conductive composition according to any one of [1] to [3], wherein a methacryloyl group content (Me content) and an alkenyl group content (Vi content), each mole-based, satisfy Expressions (2) and (3) below.

$$0.10\leq\alpha\leq 0.60\ ...(2)$$

$$\alpha = \text{Me content}/(\text{Me content} + \text{Vi content})\ ...(3).$$

[5] The thermally conductive composition according to any one of [1] to [4], wherein the content of the hydrosilyl group, H, the content of an alkenyl group, Vi, and the content of a methacryloyl group Me, each mole-based, satisfy Expression (4) below:

$$0.8\leq H/Vi\leq 1.5\ ...(4).$$

[6] The thermally conductive composition according to any one of [1] to [5], wherein the content of the hydrosilyl group, H, the content of an alkenyl group, Vi, and the content of a methacryloyl group Me, each mole-based, satisfy Expression (5) below:

$$0.4 \leq H/(Vi+Me) \leq 1.2 \ldots(5).$$

[7] The thermally conductive composition according to any one of [1] to [6], wherein a type E hardness after the thermally conductive composition is left to stand at 25°C for 24 hours, (E1), and a type E hardness after the thermally conductive composition is left to stand at 25°C for 24 hours and further at 150°C for 250 hours, (E2), satisfy the relation represented by Expression (6) below:

$$E2/E1 \leq 1.5 \ldots(6).$$

[8] The thermally conductive composition according to any one of [1] to [7], further comprising (F) an organopolysiloxane having no addition reactive group.
[9] The thermally conductive composition according to any one of [1] to [8], wherein the viscosity at a temperature of 25°C and a shear rate of 3.16 (1/s) is 10 to 1000 Pa·s.
[10] The thermally conductive composition according to any one of [1] to [9], wherein the thermally conductive filler contains aluminum oxide.
[11] A first agent usable as a thermally conductive composition by mixing with a second agent, the thermally conductive composition comprising: (A) an organopolysiloxane having an alkenyl group, (B) an organo-hydrogen polysiloxane having a hydrosilyl group, (C) a thermally conductive filler, (D) a polysiloxane compound having a methacryloyl group, and (E) a hydrosilylation catalyst, the first agent containing at least one of the component (A) or component (D); and the component (E) but not containing the component (B), and in a case where the first agent is combined with the second agent, a weight average molecular weight of the component (D), $M_{wd}$, is smaller than a weight average molecular weight of the component (A), $M_{wa}$.
[12] A second agent usable as a thermally conductive composition by mixing with a first agent, the thermally conductive composition comprising: (A) an organopolysiloxane having an alkenyl group, (B) an organo-hydrogen polysiloxane having a hydrosilyl group, (C) a thermally conductive filler, (D) a polysiloxane compound having a methacryloyl group, and (E) a hydrosilylation catalyst, the second agent containing the component (B) but not containing the component (E), and in a case where the second agent is combined with the first agent, a weight average molecular weight of the component (D), $M_{wd}$, is smaller than a weight average molecular weight of the component (A), $M_{wa}$.
[13] A thermal conductive member which is a cured product of the thermally conductive composition according to any one of [1] to [10].
[14] An electrical component, wherein a thermal conductive member which is a cured product of the thermally conductive composition according to any one of [1] to [10] is interposed between a heating element and a heat-dissipating element.
[15] The electrical component according to [14], wherein the heating element is disposed at least in an engine room or near a motor.
[16] The electrical component according to [14] or [15], wherein the electrical component is exposed to an environment at 150°C or more.
[17] A method for use, comprising interposing a thermal conductive member which is a cured product of the thermally conductive composition according to any one of [1] to [10] between a heating element and a heat-dissipating element.
[18] The method for use according to [17], wherein the heating element is a semiconductor element.
[19] The method for use according to [17] or [18], wherein the heating element generates heat of 150°C or more.

## Advantageous Effects of Invention

The present invention can provide a thermally conductive composition which can be formed into a thermal conductive member whose hardness is less likely to increase even under a high temperature environment at 150°C or more.

## Description of Embodiments

### [Thermally conductive composition]

Hereinafter, the thermally conductive composition according to the present invention will be specifically described.
The thermally conductive composition according to the present invention comprises the following components (A) to (E). Hereinafter, the components (A) to (E) will be described in detail.

<Component (A)>

The component (A) is an organopolysiloxane having an alkenyl group. The thermally conductive composition, which contains the component (A), can be formed into a cured product having appropriate hardness through an addition reaction of the component (A) with organo-hydrogen polysiloxanes described later. The component (A) can also be a mixture of a plurality of organopolysiloxanes having an alkenyl group. The organopolysiloxane having the alkenyl group used as the component (A) may be linear or branched, or may be a mixture of linear and branched ones. Preferably, the organopolysiloxane is linear.

The alkenyl group in the component (A) may be contained either in a terminal of the chain or in the middle of the chain of the polysiloxane structure of the component (A), or may be contained both in a terminal of the chain and in the middle of the chain. The alkenyl group is preferably contained in at least a terminal of the chain, more preferably contained in both the terminals of the chain composed of the polysiloxane structure, still more preferably contained in only both terminals of the chain.

Examples of the alkenyl group include, but not particularly limited to, $C_2$ to $C_8$ alkenyl groups, and examples thereof include a vinyl group, an allyl group, a butenyl group, a pentenyl group, a hexenyl group, a heptenyl group, and an octenyl group. Among these, a vinyl group is preferred in view of ease in synthesis and reactivity. The alkenyl group is preferably an alkenyl group directly bonded to a silicon atom.

The number of alkenyl groups in one molecule of the component (A) can be one or more, and is preferably 2 or more, more preferably 2 to 4, still more preferably 2 to 3, further still more preferably 2.

The component (A) may contain a plurality of components, i.e., organopolysiloxanes having different numbers of alkenyl groups. In view of imparting predetermined curability to the thermally conductive composition, the organopolysiloxane contained as the main component has preferably 2 or more alkenyl groups, more preferably 2 to 4 alkenyl groups, still more preferably 2 to 3 alkenyl groups, further still more preferably 2 alkenyl groups. The main component indicates the component contained in the highest proportion among the organopolysiloxanes in the component (A). Preferably, an organopolysiloxane having 2 or more alkenyl groups accounts for, for example, 50 to 100 mass%, preferably 70 to 100 mass% of the component (A).

Herein, a range expressed with "to" indicates the range from the specific numeric value stated before "to" to the other specific numeric value stated after "to", inclusive.

Examples of groups other than the alkenyl group which are bonded to the silicon atom include alkyl groups such as a methyl group, an ethyl group, a propyl group, a butyl group, a hexyl group, and a dodecyl group; aryl groups such as a phenyl group; and aralkyl groups such as a 2-phenylethyl group and a 2-phenylpropyl group. Other specific examples include substituted hydrocarbon groups such as a chloromethyl group and a 3,3,3-trifluoropropyl group. Among these, a methyl group is preferred in view of ease in synthesis. Of the other groups bonded to the silicon atom, preferably 80 mol% or more, more preferably 90 mol% or more, still more preferably 100 mol% of them is preferably a methyl group. Preferably, the component (A) does not contain a hydrogen atom as the other groups bonded to the silicon atom, that is, the component (A) does not contain a hydrosilyl group.

These organopolysiloxanes for the component (A) may be used singly or in combination of two or more thereof.

In the thermally conductive composition according to the present invention, as described later, the weight average molecular weight of the component (A), $M_{wa}$, can be larger than the weight average molecular weight of the component (D), $M_{wd}$. In view of readily suppressing an increase in hardness of the cured product and preventing an excessive increase in cross-linking density of the cured product to readily maintain the flexibility after curing, the weight average molecular weight of the component (A), $M_{wa}$, is preferably 12000 or more, more preferably 15000 or more, still more preferably 18000 or more. In view of preventing a high viscosity of the thermally conductive composition and imparting given reactivity, $M_{wa}$ is preferably 35000 or less, more preferably 32000 or less, still more preferably 27000 or less.

In view of compatibility of readily suppressing an increase in hardness of the cured product and preventing an excessive increase of the cross-linking density of the cured product to maintain the flexibility after curing with preventing high viscosity of the thermally conductive composition and imparting given reactivity, the weight average molecular weight of the component (A), $M_{wa}$, is preferably 12000 to 35000, more preferably 15000 to 32000, still more preferably 18000 to 27000.

Here, the weight average molecular weight of the component (A), $M_{wa}$, indicates the weight average molecular weight of all the components (A) contained in the thermally conductive composition. The same is applied to the component (D) described later.

The viscosity at 25°C of the component (A) is not particularly limited, and is, for example, 80 to 5000 mPa·s, preferably 150 to 2500 mPa·s, more preferably 200 to 1500 mPa·s, still more preferably 250 to 800 mPa·s.

The component (A) may be compounded into a mixture with the component (B) described later in some cases, and the viscosity at 25°C of the mixture of the component (A) and the component (B) is, for example, 80 to 5000 mPa·s, preferably 150 to 2500 mPa·s, more preferably 200 to 1500 mPa·s, still more preferably 250 to 800 mPa·s.

By controlling the viscosity of the component (A) or the mixture of the component (A) and the component (B) to the above-mentioned lower limit or higher, an excessively high cross-linking density of the cured product is prevented, and the flexibility after curing is readily maintained. By controlling the viscosity to the above-mentioned upper limit or lower, an increase in viscosity of the thermally conductive composition can be prevented. Furthermore, by controlling the viscosity within the ranges above, the component (A) or the components (A) and (B) can readily have appropriate reactivity.

In the two-pack type thermally conductive composition, the viscosity at 25°C of the component (A) to be compounded into the first agent may be adjusted to fall within the ranges of viscosity above, or the viscosity at 25°C of a mixture of the components (A) and (B) to be compounded in the second agent may be adjusted to fall within the ranges of viscosity above.

The content of the component (A) is not particularly limited, for example, 20 to 70% by mass, preferably 25 to 60% by mass, more preferably 30 to 50% by mass relative to the total amount of organopolysiloxanes contained in the thermally conductive composition. The organopolysiloxanes in the total amount of the above-mentioned organopolysiloxanes indicate the total of the components (A), (B), and (D), which are involved in the addition reaction, and also the component (F), which is not involved in the addition reaction.

<Component (B)>

The component (B) is an organo-hydrogen polysiloxane having the hydrosilyl group. The thermally conductive composition, which contains the component (B), can be formed into a cured product having appropriate hardness through an addition reaction of the component (B) with the components (A) and (D).

The component (B) may be linear or branched, or may be a mixture of linear and branched ones. Preferably, the component (B) is linear. In the component (B), the hydrosilyl group may be contained in a terminal of the chain of the polysiloxane structure or in the middle of the chain, or may be contained in a terminal of the chain and in the middle of the chain. The hydrosilyl group is preferably contained in at least a terminal of the chain, and is more preferably contained in both terminals of the chain of the polysiloxane structure.

The number of hydrosilyl groups in one molecule of the component (B) is not particularly limited, and can be one or more. The number thereof is preferably 2 or more, more preferably 2 to 25, still more preferably 2 to 20.

In the component (B), a component having two hydrosilyl groups, (B-1), and a component having three or more hydrosilyl groups, (B-2), may be used in combination. Preferably, the component having two hydrosilyl groups is linear and has the hydrosilyl groups in both terminals, respectively, of the chain of the polysiloxane structure, for example, but not particularly limited thereto. The component having three or more hydrosilyl groups has preferably 3 to 25, more preferably 3 to 20 hydrosilyl groups in one molecule.

In the component (B), examples of other groups bonded to the silicon atom than the hydrosilyl group include alkyl groups such as a methyl group, an ethyl group, a propyl group, a butyl group, a hexyl group, and a dodecyl group; aryl groups such as a phenyl group; and aralkyl groups such as a 2-phenylethyl group and a 2-phenylpropyl group. Other specific examples include substituted hydrocarbon groups such as a chloromethyl group and a 3,3,3-trifluoropropyl group. Among these, a methyl group is preferred in view of ease in synthesis. Of the other groups bonded to the silicon atom, preferably 80 mol% or more, more preferably 90 mol% or more, still more preferably 100 mol% of them is a methyl group. Preferably, the component (B) does not contain an alkenyl group as other groups bonded to the silicon atom, that is, the component (B) does not contain an alkenyl group.

These organopolysiloxanes for the component (B) may be used singly or in combination of two or more thereof.

The lower limit of the viscosity at 25°C of the component (B) is not particularly limited, and the viscosity is, for example, 10 mPa·s or more, preferably 40 mPa·s or more, more preferably 80 mPa·s or more.

The upper limit of the viscosity at 25°C of the component (B) is not particularly limited, and the viscosity is, for example, 2000 mPa·s or less, preferably 1500 mPa·s or less, more preferably 1200 mPa·s or less.

The viscosity at 25°C of the component (B) is not particularly limited, and is, for example, 10 to 2000 mPa·s, preferably 40 to 1500 mPa·s, more preferably 80 to 1200 mPa·s. By controlling the viscosity of the component (B) to the above-mentioned lower limit or higher, an increase in cross-linking density is easily prevented to obtain favorable flexibility after curing. In addition, excessive acceleration of the reactivity is easily prevented to allow the addition reaction to appropriately progress. By controlling the viscosity of the component (B) to the above-mentioned upper limit or lower, a reduction in reactivity or high viscosity of the thermally conductive composition can be prevented. Furthermore, by controlling the viscosity within the ranges above, the component (B) can readily have appropriate reactivity.

The content of the component (B) can be appropriately selected such that the content ratio H/Vi described later is adjusted to fall within a predetermined range, and is not particularly limited. The content is, for example, 3 to 35 mass%, preferably 5 to 30 mass%, more preferably 8 to 25 mass% relative to the total amount of organopolysiloxanes contained in the thermally conductive composition.

<Component (C)>

The component (C) is a thermally conductive filler. Since the thermally conductive composition according to the present invention contains the thermally conductive filler, the thermally conductive composition and that of a cured product (thermal conductive member), which is a cured product of the thermally conductive composition, have improved thermal conductivity.

Examples of the thermally conductive filler include metals, metal oxides, metal nitrides, metal hydroxides, carbon materials, and oxides, nitrides, and carbides of substances other than metals. Examples of the form of the thermally conductive filler include spherical and amorphous powders.

Examples of metals for the thermally conductive filler include aluminum, copper, and nickel. Examples of metal oxides include aluminum oxide represented by alumina, magnesium oxide, and zinc oxide. Examples of metal nitrides include aluminum nitride. Examples of metal hydroxides include aluminum hydroxide. Examples of carbon materials include spherical graphite and diamond. Examples of oxides, nitrides, and carbides of substances other than metals include quartz, boron nitride, and silicon carbide. Among these, metal oxides, metal nitrides, and carbon materials are preferred, and among these, metal oxides are more preferred thermally conductive filler in view of improving thermal conductivity. Specifically, aluminum oxide, magnesium oxide, aluminum nitride, and diamond are preferred, and aluminum oxide is more preferred.

These thermally conductive fillers may be used singly or in combination of two or more thereof. Preferably, at least one of diamond, magnesium oxide, or aluminum nitride is used in combination with aluminum oxide in view of enhancing the thermal conductivity, for example. In view of the balance between the thermal conductivity and the flame retardancy, it is preferable to use aluminum oxide in combination with aluminum hydroxide.

The lower limit of the average particle size of the thermally conductive filler is not particularly limited, and in view of enhancing the thermal conductivity, the average particle size is preferably 0.1 μm or more, more preferably 0.3 μm or more, still more preferably 0.5 μm or more. The upper limit of the average particle size of the thermally conductive filler is not particularly limited, and in view of enhancing the fluidity of the thermally conductive composition, the average particle size is preferably 200 μm or less, more preferably 100 μm or less, still more preferably 70 μm or less.

Although the average particle size of the thermally conductive filler is not particularly limited, the average particle size is preferably 0.1 to 200 μm, more preferably 0.3 to 100 μm, still more preferably 0.5 to 70 μm, taking all the views described above into account.

Preferably, as the thermally conductive filler, a small particle size thermally conductive filler having an average particle size of 0.1 μm or more and 5 μm or less is used in combination with a large particle size thermally conductive filler having an average particle size of more than 5 μm and 200 μm or less. Use of thermally conductive fillers having different average particle sizes can increase the filling ratio. The average particle size indicates the 50th percentile of the volume-weighted particle size distribution (D50) of the thermally conductive filler determined by a laser diffraction/scattering method.

For the lower limit, the content of the thermally conductive filler in the thermally conductive composition is preferably 150 parts by mass or more, more preferably 500 parts by mass or more, still more preferably 1000 parts by mass or more, further still more preferably 1500 parts by mass or more per 100 parts by mass of the organopolysiloxanes contained in the thermally conductive composition.

On the other hand, for the upper limit, the content of the thermally conductive filler in the thermally conductive composition is preferably 4000 parts by mass or less, more preferably 3500 parts by mass or less, still more preferably 3200 parts by mass or less, further still more preferably 3000 parts by mass or less per 100 parts by mass of the organopolysiloxanes contained in the thermally conductive composition.

The content of the thermally conductive filler in the thermally conductive composition is preferably 150 to 4000 parts by mass, more preferably 500 to 3500 parts by mass, still more preferably 1000 to 3200 parts by mass, further still more preferably 1500 to 3000 parts by mass per 100 parts by mass of the organopolysiloxanes contained in the thermally conductive composition.

For the lower limit, the volume-based content of the thermally conductive filler is preferably 50 vol% or more, more preferably 70 vol% or more, still more preferably 75 vol% or more, further still more preferably 80 vol% or more based on the total amount of the thermally conductive composition, which is regarded as 100 vol%.

For the upper limit, the volume-based content of the thermally conductive filler is preferably 95 vol% or less, more preferably 93 vol% or less, still more preferably 92 vol% or less, further still more preferably 90 vol% or less, based on the total amount of the thermally conductive composition, which is regarded as 100 vol%.

The volume-based content of the thermally conductive filler is preferably 50 to 95 vol%, more preferably 70 to 93 vol%, still more preferably 75 to 92 vol%, further still more preferably 80 to 90 vol% based on the total amount of the thermally conductive composition, which is regarded as 100 vol%.

By controlling the content of the thermally conductive filler to the above-mentioned lower limit or higher, predetermined thermal conductivity can be imparted to the thermally conductive composition and its cured product.

By controlling the content of the thermally conductive filler to the above-mentioned upper limit or lower, the thermally conductive filler can be appropriately dispersed. An excessive increase in viscosity of the thermally conductive composition can be also prevented. Furthermore, by controlling the content of the thermally conductive filler in the range from the lower limit to the upper limit described above, the thermally conductive filler can be appropriately dispersed to prevent an excessive increase in viscosity of the thermally conductive composition while given thermal conductivity can be imparted to the thermally conductive composition and the cured product thereof.

<Component (D)>

The component (D) is a polysiloxane compound having a methacryloyl group. In the thermally conductive composition according to the present invention, the weight average molecular weight of the component (D), $M_{wd}$, is smaller than the weight average molecular weight of the component (A), $M_{wa}$. In the present invention, since the thermally conductive composition contains the component (D) having a weight average molecular weight $M_{wd}$ smaller than the weight average molecular weight of the component (A), $M_{wa}$, an increase in hardness can be suppressed even under a high temperature environment at 150°C or more. When an increase in hardness is suppressed under a high temperature environment, favorable long-term heat resistance is obtained to maintain the flexibility, and for example, peel off from the heating element and/or the heat-dissipating element is less likely to occur, so that the composition is readily kept fixed to these for a long time. Since the component (D) is involved in an addition reaction with the component (B) during curing, bleed out after curing can also be prevented.

Although the mechanism of suppression of an increase in hardness under a high temperature environment is not clarified, it is inferred as follows.

In the curing process of the thermally conductive composition according to the present invention, the addition reaction rate of the alkenyl group is higher than that of the methacryloyl group, and thus in the first half of the process, the hydrosilyl group in the component (B) preferentially reacts with the alkenyl group in the component (A). As the cross-linked structure is formed between the component (A) and the component (B) through the addition reaction, diffusion or migration of the component (A) and the component (B) in the composition becomes difficult, and as a result, unreacted alkenyl groups in the component (A) and unreacted hydrosilyl groups in the component (B) (hereinafter, also referred to as "unreacted hydrosilyl groups") are left. Subsequently, in the second half of the process, the methacryloyl group in the component (D) reacts with the hydrosilyl group in the component (B) which remains unreacted with the alkenyl group in the component (A) (hereinafter, also referred to "unreacted hydrosilyl group"). When the thermally conductive composition according to the present invention contains the component (D) having a weight average molecular weight smaller than that of the component (A), a reaction of methacryloyl groups in the component (D) with unreacted hydrosilyl groups is facilitated even in the second half of the curing process where the cross-linked structure is being formed between the component (A) and the component (B), because the component (D) readily diffuses or migrates in the cross-linked structure due to its small weight average molecular weight. Accordingly, the amount of residual unreacted hydrosilyl groups in the thermally conductive composition can be reduced, and after curing of the composition, an increase in hardness of the cured product can be suppressed even if the cured product is used under an environment at 150°C or more.

The hardness of the cured product formed through the above-mentioned curing process is substantially brought about by the cross-linked structure formed through the reaction of alkenyl groups in the component (A) with hydrosilyl groups in the component (B). For this reason, the reaction of methacryloyl groups in the component (D) with hydrosilyl groups in the component (B) gives limited influences on the hardness of the cured product. Thus, there is an advantage that even if the content of the component (D) increases or reduces, the hardness of the cured product does not change so much for the increase or reduction ratio.

$M_{wa}$ and $M_{wd}$ preferably satisfy Expression (1) below:

$$M_{wd} \times 2.3 \leq M_{wa} \text{ ...(1).}$$

When $M_{wa}$ and $M_{wd}$ satisfy Expression (1) above, the component (D) has enhanced reactivity with unreacted hydrosilyl groups, and an increase in hardness of the cured product of the thermally conductive composition can be suppressed under a high temperature environment at 150°C or more. In view of more effectively suppressing an increase in hardness of the cured product of the thermally conductive composition, $M_{wa}$ and $M_{wd}$ more preferably satisfy Expression (1-A), still more preferably satisfy Expression (1-B):

$$M_{wd} \times 2.5 \leq M_{wa} \text{ ...(1-A)}$$

$$M_{wd} \times 3.0 \leq M_{wa} \text{ ...(1-B).}$$

The upper limit of the difference between $M_{wa}$ and $M_{wd}$ is not particularly limited. By setting the difference therebetween to a predetermined value or less and controlling the weight average molecular weight of the component (A) and the component (D), appropriate reactivity with hydrosilyl groups in the component (B) can be obtained. From such a viewpoint, t in Expression (1-C) shown below is preferably 30, more preferably 10.

$$M_{wa} \leq M_{wd} \times t \ ...(1\text{-}C)$$

When the thermally conductive composition is a two-pack type thermally conductive composition which is a combination of a first agent and a second agent described later, the ratio of $M_{wa}$ and $M_{wd}$ in the whole mixture of the first agent and the second agent satisfies the relation represented by the above expression(s).

The polysiloxane compound used as the component (D) is organopolysiloxane. The organopolysiloxane for the component (D) may be linear or branched, or may be a mixture of linear and branched ones. Preferably, the organopolysiloxane is linear.

The methacryloyl group may be contained either in a terminal of the chain of the polysiloxane structure or in the middle of the chain, and is preferably contained in a terminal of the chain, and more preferably contained in one terminal of the chain of the polysiloxane structure. The component (D) preferably has one or more methacryloyl groups in the molecule. In view of obtaining a cured product having high heat resistance, the component (D) preferably has one methacryloyl group.

Although the methacryloyl group is a methacryloyl group directly bonded to a silicon atom, the methacryloyl group may be bonded to a silicon atom through any divalent group (for example, a divalent saturated aliphatic hydrocarbon group, or a group represented by - XO- (where X is a divalent saturated aliphatic hydrocarbon group, and the divalent saturated aliphatic hydrocarbon group has, for example, 1 to 18, preferably 1 to 6, more preferably 2 to 4 carbon atoms; and -XO- is preferably is bonded to the methacryloyl group via the oxygen atom)) or an oxygen atom.

Examples of other groups bonded to the silicon atom in the component (D) include the same as those listed for the component (A). In view of ease in synthesis, a methyl group is preferred. Of the other groups bonded to the silicon atom, preferably 80 mol% or more, more preferably 90 mol% or more, still more preferably 100 mol% of them is a methyl group. The component (D) does not contain a hydrogen atom as other groups bonded to the silicon atom, that is, preferably, the component (D) does not contain a hydrosilyl group.

These organopolysiloxanes for the component (D) may be used singly or in combination of two or more thereof.

The weight average molecular weight of the component (D), $M_{wd}$, is smaller than the weight average molecular weight of the component (A), $M_{wa}$, and preferably satisfies Expression (1) above. $M_{wd}$ is preferably 15000 or less, more preferably 12000 or less, still more preferably 7000 or less. When $M_{wd}$ is the above-mentioned upper limit or lower, the reaction with hydrosilyl groups remaining in the thermally conductive composition is promoted, and an increase in hardness of the cured product can be suppressed. High viscosity of the thermally conductive composition can also be prevented.

On the other hand, the lower limit of $M_{wd}$ is not particularly limited. For the lower limit, $M_{wd}$ is preferably 800 or more, more preferably 1500 or more, still more preferably 3000 or more, in view of reducing the viscosity of the thermally conductive composition.

In view of promoting the reaction with hydrosilyl groups remaining in the thermally conductive composition, suppressing an increase in hardness of the cured product, and reducing the viscosity of the thermally conductive composition, $M_{wd}$ is preferably 800 to 15000, more preferably 1500 to 12000, still more preferably 3000 to 7000.

The viscosity at 25°C of the component (D) is not particularly limited, and is, for example, 10 to 2000 mPa·s, preferably 50 to 1000 mPa·s, more preferably 80 to 600 mPa·s.

By controlling the viscosity of the component (D) to the above-mentioned lower limit or higher, the cured product is likely to have a reduced cross-linking density, and the flexibility after curing is readily enhanced. By controlling the viscosity thereof to the above-mentioned upper limit or lower, an increase in viscosity of the thermally conductive composition can be prevented. In addition, by controlling the viscosity of the component (D) within the ranges above, the component (D) can be adjusted to have appropriate reactivity.

The content of the component (D) can be appropriately selected to control the content ratio H/Vi described later within a desired range, and is not particularly limited. The content is, for example, 1 mass% or more, preferably 2 mass% or more, more preferably 3 mass% or more, further still more preferably 4 mass% or more relative to the total amount of organopolysiloxanes contained in the thermally conductive composition. The content is, for example, 55 mass% or less, preferably 50 mass% or less, more preferably 45 mass% or less, still more preferably 30 mass% or less.

Furthermore, the content of the component (D) is, for example, 1 to 55 mass%, preferably 2 to 50 mass%, more preferably 3 to 45 mass%, still more preferably 4 to 30 mass% relative to the total amount of organopolysiloxanes contained in the thermally conductive composition, without particular limitation.

<Component (E)>

The thermally conductive composition according to the present invention comprises a hydrosilylation catalyst as the component (E). Since the thermally conductive composition according to the present invention contains the hydrosilylation catalyst, an addition reaction of an organopolysiloxane having an alkenyl group with an organo-hydrogen polysiloxane can be promoted to appropriately cure the thermally conductive composition. Examples of the hydrosilylation catalyst include, but not particularly limited to, chloroplatinic acid, and complexes of chloroplatinic acid with olefins, vinyl siloxane, or an acetylene compound. The platinum group metal-based curing catalyst can be contained in the thermally conductive composition in an amount for promoting the addition reaction, and the amount is not particularly limited. For example, the amount is 0.001 to 1 part by mass, preferably 0.005 to 0.5 parts by mass per 100 parts by mass of organopolysiloxanes contained in the thermally conductive composition.

<Component (F)>

Preferably, the thermally conductive composition according to the present invention further contain an organopolysiloxane having no addition reactive group as the component (F). When the thermally conductive composition according to the present invention contains the component (F), a certain amount or more of components is not integrated into the cross-linked structure of the cured product, thus facilitating an improvement in flexibility. In addition, a reduction in viscosity of the thermally conductive composition is facilitated, and thus an improvement in handling properties is facilitated. The addition reactive group refers to a functional group reactive in an addition reaction, and typical examples thereof include alkenyl groups, a methacryloyl group, an acryloyl group, and a hydrosilyl group.

Examples of the component (F) include (F-1) silicone oil and (F-2) an organopolysiloxane having at least one alkoxy group. The component (F) may contain one of the component (F-1) and the component (F-2). Preferably, the component (F) contains at least the component (F-2). When the component (F) contains the component (F-2), the thermally conductive composition highly tends to have a reduced viscosity. When containing the component (F-2), the thermally conductive composition may further contain the component (F-1).

Examples of (F-1) silicone oil include straight silicone oils such as dimethyl silicone oil and methylphenyl silicone oil, and also non-reactive modified silicone oils having a non-reactive organic group introduced to the main chain of the polysiloxane structure, the side chain bonded to the main chain, or the terminal(s) of the main chain. The non-reactive organic group is an organic group having no addition reactive group. Examples of non-reactive modified silicone oils include polyether-modified silicone oil, aralkyl-modified silicone oil, fluoroalkyl-modified silicone oil, long-chain alkyl-modified silicone oil, higher fatty acid ester-modified silicone oil, higher fatty acid amide-modified silicone oil, and phenyl-modified silicone oil. Among these silicone oils, straight silicone oils are preferred, and among the straight silicone oils, dimethyl silicone oil is more preferred.

(F-1) silicone oils may be used singly or in combination of two or more thereof.

The component (F-2) may be linear or branched, or may be a mixture of linear and branched ones. Preferably, the component (F-2) is linear. The component (F-2) can be any organopolysiloxane having at least one alkoxy group, and is preferably an organopolysiloxane having at least one alkoxy group at the chain terminal of the polysiloxane structure, more preferably an organopolysiloxane having at least one alkoxy group only at one terminal thereof. The component (F-2), which has an alkoxy group, is likely to react or interact with the functional group present on the surface of the thermally conductive filler, particularly when it has an alkoxy group at the terminal. Moreover, the component (F-2) has a polysiloxane structure. For these reasons, it is inferred that the friction of the filler is reduced, facilitating a reduction in viscosity of the thermally conductive composition.

Specifically, the component (F-2) preferably has a structure represented by Formula (X) below:

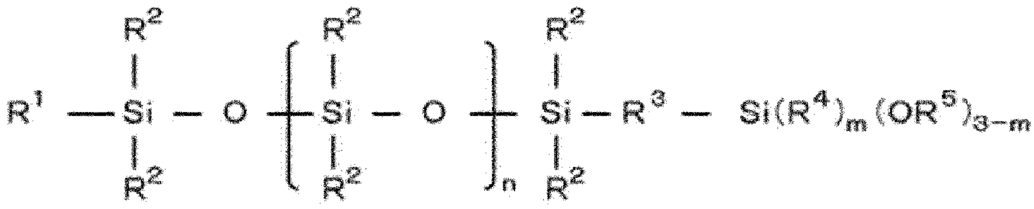

(X)

In Formula (X), $R^1$, $R^2$, $R^4$, and $R^5$ each independently represent a saturated hydrocarbon group, $R^3$ represents an oxygen atom or a divalent hydrocarbon group, n is an integer of 15 to 315, and m is an integer of 0 to 2.

Use of the component (F-2) having the structure represented by Formula (X) further enhance the effect of reducing the viscosity of the thermally conductive composition.

In Formula (X), $R^1$, $R^2$, $R^4$, and $R^5$ each independently represent a saturated hydrocarbon group. Examples of

the saturated hydrocarbon group include alkyl groups such as linear alkyl groups, branched alkyl groups, and cyclic alkyl groups, aryl groups, aralkyl groups, and alkyl halide groups.

Examples of linear alkyl groups include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an eicosyl group. Examples of branched alkyl groups include an isopropyl group, a tertiary butyl group, an isobutyl group, a 2-methylundecyl group, and a 1-hexylheptyl group. Examples of cyclic alkyl groups include a cyclopentyl group, a cyclohexyl group, and a cyclododecyl group.

Examples of the aryl groups include a phenyl group, a tolyl group, and a xylyl group. Examples of the aralkyl groups include a benzyl group, a phenethyl group, and a 2-(2,4,6-trimethylphenyl)propyl group. Examples of alkyl halide groups include a 3,3,3-trifluoropropyl group and a 3-chloropropyl group.

In Formula (X), $R^1$ to $R^5$, m, and n are preferably as defined below, in view of enhancing the viscosity reduction effect.

In Formula (X), $R^1$ is preferably a $C_1$ to $C_8$ alkyl group, more preferably a $C_2$ to $C_6$ alkyl group, particularly preferably a butyl group.

In Formula (X), $R^2$, $R^4$, and $R^5$ each independently is preferably a $C_1$ to $C_8$ alkyl group, more preferably a $C_1$ to $C_4$ alkyl group, particularly preferably a methyl group.

In Formula (X), $R^3$ is an oxygen atom or a divalent hydrocarbon group, preferably a divalent hydrocarbon group. Examples of divalent hydrocarbon groups include a methylene group, an ethylene group, a propylene group, a butylene group, and a methylethylene group. Among these, an ethylene group is preferred.

In Formula (X), n is an integer of 15 to 315, preferably an integer of 18 to 280, more preferably an integer of 20 to 220. In Formula (X), m is an integer of 0 to 2, preferably 0 or 1, more preferably 0. Accordingly, the component (F-2) is preferably an organopolysiloxane having a trialkoxysilyl group at one terminal.

These components (F-2) may be used singly or in combination of two or more thereof.

The lower limit of the viscosity at 25°C of the component (F) is not particularly limited, and the viscosity at 25°C is, for example, 1 mPa·s or more, preferably 5 mPa·s or more, more preferably 10 mPa·s or more.

On the other hand, the upper limit of the viscosity at 25°C of the component (F) is noy particularly limited, and the viscosity at 25°C is, for example, 800 mPa·s or less, preferably 250 mPa·s or less, more preferably 150 mPa·s or less.

The viscosity at 25°C of the component (F) is, for example, 1 to 800 mPa·s, preferably 5 to 250 mPa·s, more preferably 10 to 150 mPa·s, without particular limitation. By controlling the viscosity of the component (F) to the above-mentioned lower limit or higher, bleed out after curing is also readily prevented. On the other hand, by controlling the viscosity of the component (F) to the above-mentioned upper limit or lower, the viscosity of the component (F) itself is not excessively increased, whereby the viscosity of the thermally conductive composition is readily reduced, and the cured product is also readily formed. By controlling the viscosity of the component (F) within the ranges above, bleed out after curing is also readily prevented, the viscosity of the thermally conductive composition is effectively reduced by the component (F), and the cured product is also readily formed.

The content of the component (F) in the thermally conductive composition is 3 mass% or more, for example, or is 63 mass% or less, for example, relative to the total amount of organopolysiloxanes contained in the thermally conductive composition. By controlling the content of the component (F) to the above-mentioned lower limit or higher, the cured product formed from the thermally conductive composition is likely to have increased flexibility, and it becomes easier for viscosity of the thermally conductive composition to be reduced by the component (F). By controlling the content of the component (F) to the above-mentioned upper limit or lower, certain curability can be imparted to the thermally conductive composition, facilitating formation of a cured product having desired physical properties, and bleed out after curing is also prevented easily. For the lower limit, the content of the component (F) in the thermally conductive composition is preferably 5 mass% or more, more preferably 10 mass% or more, still more preferably 15 mass% or more. On the other hand, for the upper limit, the content of the component (F) in the thermally conductive composition is preferably 50 mass% or less, more preferably 40 mass% or less, still more preferably 35 mass% or less. The upper limit of the content of the component (F) in the thermally conductive composition is preferably 3 to 63 mass%, more preferably 5 to 50 mass%, still more preferably 10 to 40 mass%, further still more preferably 15 to 35 mass%.

As described above, the component (F) preferably contains the component (F-2). For the lower limit, the content of the component (F-2) in the thermally conductive composition is preferably 2 mass% or more, more preferably 4 mass% or more, still more preferably 8 mass% or more relative to the total amount of organopolysiloxanes contained in the thermally conductive composition. On the other hand, for the upper limit, the content of the component (F-2) in the thermally conductive composition is preferably 40 mass% or less, more preferably 30 mass% or less, still more preferably 20 mass% or less. The content of the component (F-2) in the thermally conductive composition is preferably 2 to 40 mass%, more preferably 4 to 30 mass%, still more preferably 8 to 20 mass%.

When the thermally conductive composition contains the component (F-2), among these components (F), in an amount equal to or larger than a predetermined amount, the thermally conductive composition highly tends to have a

reduced viscosity. By controlling the component (F) to the upper limit or lower, given curability can be imparted to the thermally conductive composition to readily obtain a cured product having desired physical properties, and bleed out after curing is also readily prevented.

For the lower limit, the total content of the components (A), (B), (D), and (F) in the thermally conductive composition according to the present invention is preferably 2 mass% or more relative to the total amount of the thermally conductive composition. For the upper limit, the total content of the components (A), (B), (D), and (F) in the thermally conductive composition according to the present invention is preferably 40 mass% or less relative to the total amount of the thermally conductive composition. By controlling the total amount of the components (A), (B), (D), and (F) to an amount equal to or larger than a predetermined amount, these components can appropriately function as the binder resin, so that the thermally conductive filler can be appropriately held by these components. By controlling the total content to an amount equal to or smaller than a predetermined amount, a large amount of the thermally conductive filler can be contained to enhance the thermal conductivity.

From the viewpoints above, for the lower limit, the total content of the components (A), (B), (D), and (F) is more preferably 3 mass% or more, still more preferably 3.5 mass% or more, further still more preferably 4 mass% or more relative to the total amount of the thermally conductive composition. On the other hand, for the upper limit, the total content of the components (A), (B), (D), and (F) is more preferably 20 mass% or less, still more preferably 15 mass% or less, further still more preferably 10 mass% or less relative to the total amount of the thermally conductive composition. The total content of the components (A), (B), (D), and (F) is more preferably 3 to 20 mass%, still more preferably 3.5 to 15 mass%, further still more preferably 4 to 10 mass% relative to the total amount of the thermally conductive composition.

The organopolysiloxanes in the thermally conductive composition according to the present invention may be composed of the components (A), (B) and (D) or the components (A), (B), (D) and (F), and may also contain a different organopolysiloxane from the components (A), (B), (D) and (F) as long as the effects of the present invention are not impaired. The content of the different organopolysiloxane from the components (A), (B), (D) and (F) is, for example, 30% by mass or less, preferably 20% by mass or less, more preferably 10% by mass or less, still more preferably 5% by mass or less, most preferably 0% by mass relative to the total amount of organopolysiloxanes contained in the thermally conductive composition.

The thermally conductive composition according to the present invention can contain a variety of additives. Examples of such additives include a reaction controller, a dispersant, a flame retardant, a plasticizer, an antioxidant, and a colorant. In the two-pack type thermally conductive composition, each additive may be contained in one of the first agent and the second agent, or may be contained in both of them. One or more additives may be appropriately selected from these additives and used.

<Content of alkenyl group and methacryloyl group>

The total content of the alkenyl group and the methacryloyl group in the total amount of the organopolysiloxanes contained in the thermally conductive composition (hereinafter, also referred to as "total Vi+Me content 1") is preferably 0.30 mmol/g or less. By controlling the total Vi+Me content 1 to 0.30 mmol/g or less, the cross-linking density of the cured product is likely to be reduced, so that favorable flexibility thereof is likely to be obtained. The total Vi+Me content 1 is more preferably 0.25 mmol/g or less, still more preferably 0.15 mmol/g or less, further still more preferably 0.12 mmol/g or less.

In view of imparting given curability and appropriate cross-linking density to the thermally conductive composition, the total Vi+Me content 1 is preferably 0.02 mmol/g or more, more preferably 0.04 mmol/g or more, still more preferably, 0.06 mmol/g or more, further still more preferably 0.08 mmol/g or more.

In view of obtaining a cured product having appropriate cross-linking density and appropriate flexibility, the total Vi+Me content is preferably 0.02 to 0.30 mmol/g, more preferably 0.04 to 0.25 mmol/g, still more preferably 0.06 to 0.15 mmol/g, further still more preferably 0.08 to 0.12 mmol/g.

In a two-pack type thermally conductive composition, the total Vi+Me content 1 can be measured in each of the first agent and the second agent, and the above-described preferred range of the total Vi+Me content 1 corresponds to the sum of the values of the first agent and the second agent.

The total content of the alkenyl group and the methacryloyl group in the thermally conductive composition (hereinafter, also referred to as "total Vi+Me content 2") is preferably 8.0 μmol/g or less. By controlling the total Vi+Me content 2 to 8.0 μmol/g or less, the cross-linking density of the cured product is likely to be reduced, so that favorable flexibility thereof is likely to be obtained. The total Vi+Me content 2 is more preferably 7.0 μmol/g or less, still more preferably 6.5 μmol/g or less, further still more preferably 6.0 μmol/g or less.

In view of imparting given curability and appropriate cross-linking density to the thermally conductive composition, the total Vi+Me content 2 is preferably 0.5 μmol/g or more, more preferably 1.0 μmol/g or more, still more preferably 2.0 μmol/g or more, further still more preferably 3.0 μmol/g or more.

In view of obtaining appropriate cross-linking density of the cured product to impart appropriate flexibility to the cured product, the total Vi+Me content 2 is preferably 0.5 to 8.0 μmol/g, more preferably 1.0 to 7.0 μmol/g, still more

preferably 2.0 to 6.5 μmol/g, further still more preferably 3.0 to 6.0 μmol/g.

The contents of the alkenyl group described above and the methacryloyl group described later can be values calculated from the integration ratios in 1H-NMR spectrum obtained using an NMR analyzer.

The content of the methacryloyl group in the total amount of the organopolysiloxanes contained in the thermally conductive composition (hereinafter, also referred to as "Me content 1") is preferably 0.15 mmol/g or less. By controlling the Me content 1 to 0.15 mmol/g or less, the residual amount of unreacted hydrosilyl groups is reduced without containing the methacryloyl group in an amount beyond necessity, and an increase in hardness under a high temperature environment after curing is thus readily suppressed. The Me content 1 is more preferably 0.12 mmol/g or less, still more preferably 0.08 mmol/g or less, further still more preferably 0.05 mmol/g or less.

In view of sufficiently reducing the residual amount of unreacted hydrosilyl groups in the thermally conductive composition to suppress an increase in hardness under a high temperature environment after curing, the Me content 1 is preferably 0.002 mmol/g or more, more preferably 0.004 mmol/g or more, still more preferably 0.006 mmol/g or more, further still more preferably 0.008 mmol/g or more.

In view of reducing the residual amount of unreacted hydrosilyl groups without containing the methacryloyl group in an amount beyond necessity to readily suppress an increase in hardness under a high temperature environment after curing, the total Me content 1 is preferably 0.002 to 0.15 mmol/g, more preferably 0.004 to 0.12 mmol/g, still more preferably 0.006 to 0.08 mmol/g, further still more preferably 0.008 to 0.05 mmol/g.

In a two-pack type thermally conductive composition, the total Me content 1 can be measured in each of the first agent and the second agent, and the above-described preferred range of the total Me content 1 corresponds to the sum of values of the first agent and the second agent.

The content of the methacryloyl group in the thermally conductive composition (hereinafter, also referred to as "Me content 2") is preferably 4.0 μmol/g or less. By controlling the Me content 2 to 4.0 μmol/g or less, the residual amount of unreacted hydrosilyl groups is reduced without containing the methacryloyl group in an amount beyond necessity, and an increase in hardness under a high temperature environment after curing is thus readily suppressed. The Me content 2 is more preferably 3.5 μmol/g or less, still more preferably 3.0 μmol/g or less, further still more preferably 2.5 μmol/g or less.

In view of sufficiently reducing the residual amount of unreacted hydrosilyl groups in the thermally conductive composition to suppress an increase in hardness under a high temperature environment after curing, the Me content 2 is preferably 0.05 μmol/g or more, more preferably 0.1 μmol/g or more, still more preferably 0.2 μmol/g or more, further still more preferably 0.3 μmol/g or more.

In view of reducing the residual amount of unreacted hydrosilyl groups without containing the methacryloyl group in an amount beyond necessity to readily suppress an increase in hardness under a high temperature environment after curing, the total Me content 2 is preferably 0.05 to 4.0 μmol/g, more preferably 0.1 to 3.5 μmol/g, still more preferably 0.2 to 3.0 μmol/g, further still more preferably 0.3 to 2.5 μmol/g.

The total content of the alkenyl group in the total amount of the organopolysiloxanes contained in the thermally conductive composition is hereinafter referred to as "total Vi content 1", and the total content of the alkenyl group in the thermally conductive composition is hereinafter referred to as "total Vi content 2". The total of the "Me content 1" and the "total Vi content 1" is "total Vi+Me content 1", and the total of the "Me content 2" and the "total Vi content 2" is "total Vi+Me content 2".

The Me content 2 and the total Vi content 2 (each mole-based) preferably satisfy Expressions (2) and (3) below:

$$0.10 \leq \alpha \leq 0.60 \quad ...(2)$$

$$\alpha = \text{Me content 2}/(\text{total Vi+Me content 2}) \quad ...(3).$$

By controlling the proportion of the Me content in the total Vi+Me content to a value equal to or greater than a predetermined value as shown in Expressions (2) and (3) above, the residual amount of unreacted hydrosilyl groups in the thermally conductive composition can be reduced, an excessive increase in density of cross-linking points can be prevented, and an increase in hardness of the cured product can be suppressed under a high temperature environment. The Me content is more preferably 0.15 or more, still more preferably 0.19 or more relative to the total Vi+Me content. In view of reducing the residual amount of unreacted hydrosilyl groups without containing the methacryloyl group in an amount beyond necessity to suppress an increase in hardness under a high temperature environment after curing, the Me content is more preferably 0.55 or less, still more preferably 0.50 or less relative to the total Vi+Me content.

The Me content is preferably 0.15 to 0.55, more preferably 0.19 to 0.50 or more relative to the total Vi+Me content.

In the thermally conductive composition, the content of the alkenyl group contained in the component (A) having an alkenyl group at only one terminal of the component (A) (i.e., the organopolysiloxane having an alkenyl group) (hereinafter, also referred to as "DVi content") is preferably 0.17 or less, more preferably 0.15 or less, still more preferably 0.10 or less, further still more preferably 0.05 or less relative to the total Vi+Me content, in view of imparting given curability

to the thermally conductive composition. In view of imparting an appropriate cross-linked structure to the cured product, a smaller DVi content relative to the total Vi+Me content is better, and may be 0 or more.

<Content ratio H/Vi>

In the thermally conductive composition, the content of the hydrosilyl group, H, and the content of the alkenyl group, Vi, (each mole-based) preferably satisfy the relation represented by Expression (4) below:

$$0.8 \leq H/Vi \leq 1.5 \ ...\cdot(4).$$

Since the thermally conductive composition according to the present invention contains the component (D), favorable curability of the thermally conductive composition can be provided, when the relation represented by Expression (4) above is satisfied, and the thermally conductive composition can thus be appropriately cured even at normal temperature, for example. The effect of suppressing an increase in hardness of the cured product of the thermally conductive composition is enhanced even in a high temperature environment at 150°C or more. In view of reducing the amount of unreacted alkenyl groups, H/Vi described above is preferably 0.95 or more, more preferably 1.05 or more. On the other hand, in view of reducing the amount of unreacted hydrosilyl groups, H/Vi described above is preferably 1.40 or less, more preferably 1.20 or less. In view of reducing the amount of unreacted addition reactive groups to suppress an increase in hardness of the cured product of the thermally conductive composition, H/Vi is more preferably 0.95 to 1.40, still more preferably 1.05 to 1.20.

Irrespective of the value of H/Vi, unreacted alkenyl groups and unreacted hydrosilyl groups remain in the first half of the curing process. Thus, even if H/Vi is 1 or less, an increase in hardness of the cured product of the thermally conductive composition can be suppressed by reacting unreacted hydrosilyl groups with the component (D) in the second half of the curing process. On the other hand, when the residual amount of unreacted alkenyl groups is a problem, the amount of unreacted alkenyl groups can be reduced by increasing the content of the hydrosilyl group, H, compared to the content of the alkenyl group, Vi, and further, an increase in hardness of the cured product of the thermally conductive composition can be suppressed by reacting the unreacted hydrosilyl groups with the component (D) in the second half of the curing process.

<Content ratio H/(Vi+Me)>

In the thermally conductive composition, the content of the hydrosilyl group, H, the content of the alkenyl group, Vi, and the content of the methacryloyl group, Me, (each mole-based) preferably satisfy the relation represented by Expression (5) below:

$$0.4 \leq H/(Vi+Me) \leq 1.2 \ ...\cdot(5).$$

When the thermally conductive composition according to the present invention satisfies the relation represented by Expression (5) above, favorable curability of the thermally conductive composition can be obtained, and the thermally conductive composition can be appropriately cured even at normal temperature, for example. The effect of suppressing an increase in hardness of the cured product of the thermally conductive composition is enhanced even in a high temperature environment at 150°C or more.

In view the curability, H/(Vi+Me) is preferably 0.50 or more, more preferably 0.55 or more. In view of suppressing an increase in hardness, H/(Vi+Me) is preferably 1.05 or less, more preferably 0.95 or less.

Furthermore, in view of the curability and suppression of an increase in hardness, H/(Vi+Me) is preferably 0.50 to 1.05, more preferably 0.55 to 0.95.

The content ratio H/Vi and the content ratio H/(Vi+Me) can be calculated from the amounts of the functional groups of the components contained and the contents of the components. The amounts of the functional groups of the components contained can be calculated from the integration ratios in the 1H-NMR spectrum as described above.

When the relation represented by Expression (5-2) below is satisfied, the thermally conductive composition contains the methacryloyl group, and thus an increase in hardness of the cured product of the thermally conductive composition can be suppressed under a high temperature environment.

$$H/(Vi+Me) < H/Vi \ ...(5\text{-}2)$$

<Type E hardness>

Preferably, in the thermally conductive composition according to the present invention, a type E hardness (E1) after the composition is left to stand at 25°C for 24 hours and a type E hardness (E2) after the composition is left to stand at 25°C for 24 hours and further at 150°C for 250 hours satisfy the relation represented by Expression (6) below:

$$E2/E1 \leq 1.5 \quad ...(6).$$

When E2/E1 is 1.5 or less, the hardness after curing does not excessively largely change. Thus, favorable heat resistance is obtained, and for example, peel off from the heating element and/or the heat-dissipating element is less likely to occur, whereby stable fixation can be obtained. From such a viewpoint, E2/E1 is more preferably 1.45 or less. On the other hand, the lower limit of E2/E1 is not particularly limited, and E2/E1 is, for example, 1 or more, preferably 1.15 or more for practical use.

The type E hardness in the present invention is a value measured with a type E durometer according to Japanese Industrial Standards JIS K 6253.

The thermally conductive composition has a type E hardness (E1) of preferably 40 or more, more preferably 45 or more, still more preferably 50 or more. When the type E hardness (E1) of the thermally conductive composition is the predetermined value or larger, a cured product having predetermined hardness can be obtained only by leaving such a thermally conductive composition at normal temperature. Thus, for example, such a cured product in a state after being cured at normal temperature can sufficiently hold the weight of a member disposed on the cured product to prevent compression thereof in the thickness direction when used. The thermally conductive composition has a type E hardness (E1) of preferably 65 or less, more preferably 62 or less, still more preferably 60 or less. By controlling the type E hardness (E1) to the above-mentioned upper limit or lower, the cured product of the thermally conductive composition can have improved flexibility.

The type E hardness (E2) of the thermally conductive composition preferably satisfies Expression (7-2) below:

$$E2 < 80 \quad ...(7\text{-}2).$$

When the thermally conductive composition is a two-pack type thermally conductive composition, the first agent and the second agent can be mixed, and can be left to stand at 25°C for 24 hours. The same is applied to the measurement of the hardness in other conditions.

When the type E hardness (E2) described above is less than 80, the flexibility of the cured product is readily maintained under an environment at 150°C or more, and stress such as vibration is readily relaxed. Thus, peel off thereof from the heating element and/or the heat-dissipating element is less likely to occur. For this reason, when the cured product of the thermally conductive composition is used as a heat-dissipating gap filler (thermal conductive member) under an environment at 150°C or more, occurrence of peel off from the heating element and/or the heat-dissipating element and an increase in heat resistance can be prevented, and reliability can be maintained. In view of the flexibility and the reliability, the type E hardness (E2) is preferably 75 or less, more preferably 73 or less, still more preferably 70 or less. When the flexibility is increased, buffer properties are likely to be exhibited, and the cured product can thus be suitably used under an environment where vibration occurs.

The type E hardness (E2) is, for example, 30 or more, preferably 40 or more, more preferably 50 or more, but is not particularly limited thereto. By controlling the type E hardness (E2) to a predetermined value or larger, the cured product can readily maintain flexibility under an environment at 150°C or more, and, for example, can sufficiently hold the weight of a member disposed on the cured product to prevent excessive compression of the cured product in the thickness direction when used.

The type E hardness after the cured product is left to stand at 25°C for 24 hours and further at 150°C for 1000 hours is designated as E3. A change in hardness represented by the value of E3-E2 indicates a change in hardness when the cured product is heated at 150°C for a long time. A smaller value of E3-E2 indicates a smaller change in performance and therefore more favorable long-term heat resistance even when the cured product is used at a temperature of 150°C or more for a long time. In view of the long-term heat resistance, the change in hardness represented by the value of E3-E2 is preferably 6 or less, more preferably 4 or less, still more preferably 2 or less. The change in hardness represented by the value of E3-E2 is usually 0 or more, but is not particularly limited thereto.

<Hydrosilyl group concentration ratio>

In the thermally conductive composition according to one embodiment of the present invention, the component (B-1) and the component (B-2) contained in the component (B) are preferably contained to satisfy the relation represented

by Expression (1-2) below:

$$b1/(b1+b2)>0.45 \quad ...(1-2)$$

In Expression (1-2), b1 represents the concentration of the hydrosilyl group contained in the component (B-1), and b2 represents the concentration of the hydrosilyl group contained in the component (B-2). The concentration of the hydrosilyl group herein indicates the concentration of the hydrosilyl group in the thermally conductive composition. It is noted that, in the two-pack type thermally conductive composition described later, the organo-hydrogen polysiloxanes are not contained in the first agent, and are contained only in the second agent. Thus, it can also be said that in the two-pack type thermally conductive composition, the concentration of the hydrosilyl group indicates the concentration of the hydrosilyl group in the second agent. In other words, the component (B-1) and the component (B-2) are preferably contained in the second agent to satisfy the relation represented by Expression (1-2).

In this composition, when b1/(b1+b2) is greater than 0.45, the density of cross-linking points is likely to reduce, and the cured product is thus likely to maintain favorable flexibility under an environment at 150°C or more. Accordingly, when the cured product of the thermally conductive composition is used as a heat-dissipating gap filler under an environment at 150°C or more, the cured product is less likely to peel off from the heating element and/or the heat-dissipating element, obstructing occurrence of failures such as increased heat resistance and improving the reliability. Furthermore, if the cured product has increased flexibility, it can exhibit buffer properties when the cured product has a large thickness. Such a cured product can be suitably used under an environment where vibration occurs.

In view of reducing the density of cross-linking points and obtaining more favorable reliability and flexibility, b1/(b1+b2) is preferably 0.48 or more, more preferably 0.50 or more, still more preferably 0.52 or more.

b1/(b1+b2) is preferably less than 0.85. When b1/(b1+b2) is less than 0.85, the cross-linked structure is readily introduced into the cured product in an appropriate cross-linking density. For this reason, the hardness is likely to be maintained at a predetermined value even if the cured product is heated at a high temperature for a long time, and favorable long-term heat resistance is likely to be obtained. From the viewpoint above, b1/(b1+b2) is preferably 0.75 or less, more preferably 0.70 or less, still more preferably 0.63 or less.

In the present invention, one of the requirement of Expression (1-1) and the requirement of Expression (1-2) may be satisfied, or both of them may be satisfied.

The concentration of the hydrosilyl group in the component (B-1) and that in the component (B-2) can be values calculated from the integration ratios in the 1H-NMR spectrum obtained using an NMR analyzer.

<Raman intensity ratio p2/p1>

It is preferable that in the thermally conductive composition according to one embodiment of the present invention, the Raman intensity p1 at 2160 $cm^{-1}$ and the Raman intensity p2 at 2130 $cm^{-1}$ in the Raman spectroscopy spectrum satisfy the relation represented by Expression (1-1) below:

$$p2/p1>3.00 \quad ...(1-1).$$

The Raman intensity p1 at 2160 $cm^{-1}$ in the Raman spectroscopy spectrum is the Raman intensity at the wavelength of the peak assigned to a hydrosilyl group contained in the middle of a chain of the polysiloxane structure. The Raman intensity p2 at 2130 $cm^{-1}$ in the Raman spectroscopy spectrum is the Raman intensity at the wavelength of the peak assigned to a hydrosilyl group contained in a terminal of a chain of the polysiloxane structure. Thus, it can be said that p2/p1 is an index indicating the amount of the terminal hydrosilyl groups relative to that of the hydrosilyl groups contained in the middle of chains.

By controlling p2/p1 to more than 3.0, it is likely that the amount of the hydrosilyl group contained at the terminals of the chains is increased while the amount of the hydrosilyl group contained in the middle of the chains is reduced to reduce the density of cross-linking points, and that an increase in hardness of the cured product is thus suppressed even under an environment at 150°C or more.

In view of reducing the density of cross-linking points to obtain more favorable reliability and flexibility, p2/p1 is preferably 3.10 or more, more preferably 3.20 or more, still more preferably 3.30 or more.

Preferably, p2/p1 is less than 5.5. When p2/p1 is less than 5.5, a three-dimensional cross-linked structure is readily introduced into the cured product with an appropriate cross-linking density. Accordingly, the hardness is likely to be kept at a predetermined value even when the cured product is heated at a high temperature for a long time, and favorable long-term heat resistance is thus likely to be obtained. From such a viewpoint, p2/p1 is more preferably less than 4.5, still more preferably 4.2 or less, further still more preferably 4.0 or less.

<Raman intensity ratio H/(Vi+Me)>

The ratio of the intensity of the peak assigned to the hydrosilyl group to the intensity of the peaks assigned to the alkenyl group and the methacryloyl group (also referred to as "Raman intensity ratio H/(Vi+Me)") in a spectrum from Raman spectroscopy is preferably 3.00 or more, more preferably 4.00 or more, still more preferably 5.00 or more from the viewpoint of the curability. On the other hand, in view of suppressing an increase in hardness, the Raman intensity ratio H/(Vi+Me) is preferably 12.00 or less, more preferably 10.00 or less, still more preferably 9.00 or less.

The Raman intensity ratio H/(Vi+Me) is preferably 3.00 to 12.00, more preferably 4.00 to 10.00, still more preferably 5.00 to 9.00. By controlling the Raman intensity ratio H/(Vi+Me) within the above ranges, the number of hydrosilyl groups and the total number of alkenyl groups and methacryloyl groups are balanced, and it is thus likely that the components (A), (B), and (D) are appropriately cured, and that curing appropriately progresses even under normal temperature, for example. An increase in hardness under a high temperature environment after curing is also likely to be suppressed.

<Raman intensity ratio H/Vi>

In view of reducing the amount of unreacted alkenyl groups, the ratio of the intensity of the peak assigned to the hydrosilyl group to the intensity of the peak assigned to the alkenyl group (also referred to as "Raman intensity ratio H/Vi") in the spectrum from Raman spectroscopy is preferably 7.00 or more, more preferably 8.00 or more, still more preferably 9.50 or more. On the other hand, in view of reducing the amount of unreacted hydrosilyl groups, the Raman intensity ratio H/Vi is preferably 14.00 or less, more preferably 12.50 or less, still more preferably 11.00 or less.

In view of reducing the amount of unreacted addition reactive groups to suppress an increase in hardness of the cured product of the thermally conductive composition, the Raman intensity ratio H/Vi is preferably 7.00 to 14.00, more preferably 8.00 to 12.50, still more preferably 9.50 to 11.00.

The Raman intensity ratio H/Vi is a value greater than the Raman intensity ratio H/(Vi+Me).

For obtaining the Raman spectroscopy spectrum of the thermally conductive composition, at least the organopolysiloxanes may be separated from the thermally conductive filler, and the organopolysiloxanes may be subjected to Raman spectroscopy. At this time, the organopolysiloxanes may be contaminated with a component other than the organopolysiloxanes as long as the component does not affect the spectroscopy. Thus, usually, a liquid component may be separated from a solid component by centrifuge, for example, and the liquid component may be subjected to Raman spectroscopy to obtain a spectrum.

For the two-pack type thermally conductive composition, the first agent and the second agent can be separately subjected to Raman spectroscopy, and the Raman intensity ratio p2/p1, H/Vi and H/(Vi+Me) can be calculated. Preferably, the Raman intensity ratio p2/p1 is calculated from the Raman spectroscopy spectrum of the second agent. This is because the organo-hydrogen polysiloxanes are not contained in the first agent, and are contained only in the second agent. The conditions for Raman spectroscopy are as described below. The alkenyl group is typically a vinyl group, and the above-mentioned Raman intensity ratio H/Vi can be typically obtained by calculating, as an index, the ratio of hydrosilyl group/vinyl group as described later. The above-mentioned Raman intensity ratio H/Vi can be typically obtained by calculating, as an index, the ratio of hydrosilyl group/(vinyl group + methacryloyl group) as described later.

Hereinafter, a specific example of Raman spectroscopy will be described. In this example, the thermally conductive composition is of a two-pack type, and the alkenyl group is a vinyl group. The method of Raman spectroscopy is, however, not limited to the following method.

For each of the first agent and the second agent, the liquid components are separated from the solid component (thermally conductive filler) using a centrifuge. For the separated liquid components of each agent, Raman spectrum is obtained. The conditions for the Raman spectroscopy to be used are as follows, for example.

apparatus: available from RENISHAW, inVia Raman microscope QONTOR
spectrum range: 300 to 2500 $cm^{-1}$
wavelength of laser light: 532 nm, 100 mW (reduced to 10%)
grating: 1800 lines/mm
irradiation time: 1.0 s
integration: 100
object lens: x50

The Raman intensity ratio p2/p1 is estimated from the Raman intensity p2 at a wave number of 2130 $cm^{-1}$ and the Raman intensity p1 at a wave number of 2160 $cm^{-1}$ in the spectrum of the Raman spectroscopy obtained from the second agent containing the hydrosilyl group.

The Raman intensity ratio H/Vi (ratio of the intensity of the peak assigned to the hydrosilyl group to the intensity of

the peak assigned to the alkenyl group) is calculated as follows. Specifically, in the Raman spectrum of the first agent and the Raman spectrum of the second agent, the area C of the peak of Si-O-Si appearing at a wave number of 490 $cm^{-1}$, the area D of the peak of the vinyl group appearing at a wave number of 1600 $cm^{-1}$, and the area F of the peak of the hydrosilyl group appearing at a wave number of 2130 to 2160 $cm^{-1}$ are first calculated. Next, the following calculations are performed on the basis of the area C, and errors of the intensity in the runs were corrected to normalize.

$$\text{area D/area C} = \text{area proportion D1}$$

$$\text{area F/area C} = \text{area proportion F1}$$

Subsequently, the value obtained by multiplying the area proportion D1 of the first agent by the mass proportion of the liquid components contained in the first agent and the value obtained by multiplying the area proportions D1 and F1 of the second agent by the mass proportion of the liquid components contained in the second agent are added to estimate D1 and F1 in the thermally conductive composition.
Then, as an index, the ratio of hydrosilyl group/vinyl group is determined by calculation of the following expression.
Raman intensity ratio H/Vi = area proportion F1/area proportion D1
The Raman intensity ratio H/(Vi+Me) (ratio of the intensity of the peak assigned to the hydrosilyl group to the intensity of the peaks assigned to the alkenyl group and the methacryloyl group) is calculated as follows. Specifically, in the Raman spectrum of the first agent and the Raman spectrum of the second agent, the area C of the peak of Si-O-Si appearing at a wave number of 490 $cm^{-1}$, the area D of the peak of the vinyl group appearing at a wave number of 1600 $cm^{-1}$, the area E of the peak of the methacryloyl group appearing at a wave number of 1640 $cm^{-1}$, and the area F of the peak of the hydrosilyl group appearing at a wave number of 2130 to 2160 $cm^{-1}$ are first calculated. Next, the following calculations were performed on the basis of the area C, and errors of the intensity in the runs were corrected to normalize.

$$\text{area D/area C} = \text{area proportion D1}$$

$$\text{area E/area C} = \text{area proportion E1}$$

$$\text{area F/area C} = \text{area proportion F1}$$

Subsequently, values obtained by multiplying the area proportions D1 and E1 of the first agent by the mass proportion of the liquid components contained in the first agent, and values obtained by multiplying the area proportions D1, E1, and F1 of the second agent by the mass proportion of the liquid components contained in the second agent are added to estimate D1, E1, and F1 in the thermally conductive composition.
Then, as an index, the ratio of the hydrosilyl group/(vinyl group + methacryloyl group) is determined by calculation of the following expression. Since there is a difference in Raman scattering intensity between the vinyl group and the methacryloyl group, calculation is performed by multiplying 0.5 as a correction coefficient.

Raman intensity ratio H/(Vi+Me) = area proportion F1/[area proportion D1+(area proportion E1×0.5)]

When the thermally conductive composition has an alkenyl group other than the vinyl group, the peak intensity assigned to the alkenyl group other than the vinyl group may also be calculated as above to calculate the Raman intensity ratio H/Vi and the Raman intensity ratio H/(Vi+Me).

<Two-pack type thermally conductive composition>

The thermally conductive composition according to the present invention may be a one-pack type, or may be a two-pack type composed of a combination of a first agent and a second agent. In view of the storage stability, the two-pack type is preferred. The two-pack type thermally conductive composition is prepared by mixing the first agent with the second agent when used.
In the two-pack type thermally conductive composition, the mass ratio between the first agent and the second agent (second agent/first agent) is preferably 1 or a value close to 1, more preferably 0.8 to 1.2, more preferably 0.9 to 1.1, still more preferably 0.95 to 1.05. When the mass ratio between the first agent and the second agent is 1 or a value close to 1 as above, preparation of the thermally conductive composition is easy.

For the two-pack type thermally conductive composition, there is no limitation on the method for mixing the first agent with the second agent to prepare a thermally conductive composition. For example, a static mixer, a mixer having a stirring blade, a vibration stirrer, or a planetary mixer can be used.

In the two-pack type thermally conductive composition, the first agent contains an organopolysiloxane having one of an alkenyl group or a methacryloyl group (alkenyl group-containing organopolysiloxane) and (E) a hydrosilylation catalyst, but not organo-hydrogen polysiloxane. The second agent contains an organo-hydrogen polysiloxane, and does not contain (E) the hydrosilylation catalyst. Furthermore, at least one of the first agent or the second agent contains (C) the thermally conductive filler. Preferably, both of the first agent and the second agent contain (C) the thermally conductive filler.

More specifically, the first agent contains at least one of the components (A) or (D); and the component (E), and does not contain the component (B). On the other hand, the second agent contains the component (B), but not the component (E). At least one of the first agent or the second agent contains the component (C).

The first agent contains at least one of the components (A) or (D), the component (C), and the component (E), but not the component (B). On the other hand, more preferably, the second agent contains the component (B) and the component (C), but not the component (E).

Since the first agent having such a configuration contains (E) the hydrosilylation catalyst, which accelerates the addition reaction, and does not contain the organo-hydrogen polysiloxane, progress of the addition reaction before the second agent is mixed can be prevented. Since the second agent contains the organo-hydrogen polysiloxane and does not contain (E) the hydrosilylation catalyst, which accelerates the addition reaction, progress of the addition reaction before the first agent is mixed can be prevented.

All of the organopolysiloxane containing either the alkenyl group or the methacryloyl group for constituting the thermally conductive composition may be contained in the first agent. Preferably, part of the organopolysiloxane containing either the alkenyl group or the methacryloyl group is contained in the first agent, and the remainder thereof is contained in the second agent. More specifically, all of the components (A) and (D) for the thermally conductive composition may be contained in the first agent. Preferably, part of the components (A) and (D) is contained in the first agent, and the remainder of the components (A) and (D) is contained in the second agent.

When the organopolysiloxanes containing either the alkenyl group or the methacryloyl group are divided and contained in the first agent and the second agent as above, the first agent and the second agent are each readily controlled to have a viscosity in a desired range, and the mass ratio between the first agent and the second agent is also readily controlled to 1 or a value close to 1. Since the second agent also contains the organo-hydrogen polysiloxanes but does not contain (E) the platinum group metal-based curing catalyst, such a second agent can substantially inhibit progression of the addition reaction for example during storage even if the second agent contains the organopolysiloxane containing either the alkenyl group or the methacryloyl group. A reaction controller may be contained in the second agent to prevent progression of the reaction in the second agent.

When the organopolysiloxane containing either the alkenyl group or the methacryloyl group is contained in the second agent, a mixture thereof with the organo-hydrogen polysiloxane may be incorporated into the second agent. For example, the component (A) may be mixed with the component (B) and the mixture may be incorporated into the second agent.

All of the organo-hydrogen polysiloxanes for constituting the thermally conductive composition are contained in the second agent, but not contained in the first agent.

(C) the thermally conductive filler may be contained one of the first agent and the second agent for forming the thermally conductive composition. However, as described above, (C) the thermally conductive filler is preferably contained in both of the first agent and the second agent, and more preferably, (C) the thermally conductive filler is substantially equally contained in these agents. Specifically, the ratio (mass ratio) of the content of (E) the thermally conductive filler in the second agent to the content of (C) the thermally conductive filler in the first agent is preferably 0.67 to 1.5, more preferably 0.83 to 1.2, still more preferably 0.91 to 1.1. By substantially equally distributing (C) the thermally conductive filler to the first agent and the second agent, the difference in viscosity between the first agent and the second agent is readily reduced, and the mass ratio of the first agent to the second agent is also readily controlled to or around 1.

The thermally conductive composition preferably contains the component (F), and the component (F) may be contained in at least one of the first agent or the second agent. The component (F) is preferably contained in at least the first agent, more preferably contained in both of the first agent and the second agent. By containing the component (F) in both of the first agent and the second agent, the viscosities of the first agent and the second agent can be controlled by the component (F), and both of the first agent and the second agent can be each controlled to have a relatively low viscosity. When the component (F) contains the component (F-2), it is effective and preferred that the component (F-2) is contained in both of the first agent and the second agent.

< Viscosity>

The viscosity VB at 25°C of the binder resin contained in the thermally conductive composition is not particularly limited, and is preferably 50 to 800 mPa·s, more preferably 80 to 600 mPa·s, still more preferably 100 to 400 mPa·s. The viscosity VB of the binder resin indicates the viscosity of the organopolysiloxane contained in the thermally conductive composition, and is usually the viscosity of a mixture of the components (A) to (D) or the components (A) to (D) and (F). When an organopolysiloxane other than these is contained, the viscosity VB indicates the viscosity of a mixture further containing the other organopolysiloxane. The viscosities VB1 and VB2 of the binder resins in the first agent and the second agent described later also indicate the viscosities of the organopolysiloxanes contained in the first agent and the second agent, respectively.

In the two-pack type thermally conductive composition, the viscosities VB1 and VB2 at 25°C of the binder resins in the first agent and the second agent are each preferably 50 to 800 mPa·s, more preferably 80 to 600 mPa·s, still more preferably 100 to 400 mPa·s.

The viscosities VB1 and VB2 of the binder resins in the first agent and the second agent can be measured by mixing the organopolysiloxanes contained in each of the first agent and the second agent, and measuring the viscosity of the resulting organopolysiloxanes. The viscosity VB of the binder resin in the thermally conductive composition can also be measured in the same manner as above. For the two-pack type thermally conductive composition, an approximate viscosity VB can be estimated from the viscosities VB1 and VB2 of the binder resins in the first agent and the second agent, respectively.

The viscosities at 25°C of the organopolysiloxanes and the viscosities of the binder resins contained in the first agent and the second agent, VB1 and VB2, can be measured as follows.

Using a rheometer (for example, rheometer "MCR-302e" available from Anton Paar GmbH), the temperature of a sample is adjusted to 25°C with a peltier plate, and the viscosity is measured using a cone plate of ϕ50 mm with an angle of 1° while the shear rate is continuously varied in the range of the shear rate of 10 to 100 (1/sec). The value of the viscosity to be used is the viscosity at a shear rate of 10 (1/s).

In the two-pack type thermally conductive composition, the viscosities V1 and V2 of the first agent and the second agent, respectively, at a temperature of 25°C and a shear rate of 3.16 (1/s) are preferably 10 to 1000 Pa·s, more preferably 50 to 700 Pa·s, still more preferably 200 to 450 Pa·s. The first agent and the second agent each having the viscosity described above facilitate an improvement in handling properties.

The viscosity V of the thermally conductive composition according to the present invention at a temperature of 25°C and a shear rate of 3.16 (1/s) is preferably 10 to 1000 Pa·s, more preferably 50 to 700 Pa·s, still more preferably 200 to 450 Pa·s. The thermally conductive composition having such a viscosity has predetermined fluidity before curing, and can be applied to narrow gaps and complex shapes.

For the two-pack type thermally conductive composition, the viscosity V can be determined by mixing the first agent and the second agent, and immediately measuring the viscosity. Alternatively, an approximate viscosity can be estimated from the viscosities V1 and V2 of the first agent and the second agent.

In view of facilitating homogenous mixing of the thermally conductive composition, the difference between the viscosity V1 of the first agent and the viscosity V2 of the second agent (|V1-V2|) is preferably small. Specifically, the difference in viscosity between the first agent and the second agent (|V1-V2|) can be 130 Pa·s or less, for example. The difference is preferably 100 Pa·s or less, more preferably 30 Pa·s or less. The difference in viscosity between the first agent and the second agent (|V1-V2|) can be 0 Pa·s or more.

The viscosities of the first agent and the second agent, V1 and V2, can be measured by the following method.

Using a rheometer "MCR-302e" available from Anton Paar GmbH, the temperature of a sample is adjusted to 25°C with a peltier plate, and the viscosity is measured using a parallel plate of ϕ25 mm while the shear rate is continuously varied in the range of shear rates of 0.0001 to 100 (1/s). The viscosity at the shear rate above can be read.

[Thermally conductive member]

Preferably, the thermally conductive composition according to the present invention is used in the form of a thermally conductive member such as a heat-dissipating gap filler. The thermally conductive member is a cured product formed by curing the thermally conductive composition.

The thermally conductive member is used inside an electronic device or the like. Specifically, the thermally conductive member is interposed between a heating element and a heat-dissipating element to conduct heat generated in the heating element to the heat-dissipating element by heat conduction and dissipate the heat from the heat-dissipating element. Here, examples of the heating element include a variety of electronic parts such as CPUs, power amplifiers, power supplies and semiconductor elements used inside electronic devices. Examples of the heat-dissipating element include heat sinks, heat pumps, and metal housings for electronic devices.

The thermal conductive member is preferably used in electrical components. In the electrical components, the

heating element is preferably disposed at least either inside the engine room or near the motor, and the present invention is suitable for use as electrical components exposed to a high temperature environment at 150°C or more in particular. The present invention is also suitable for dissipation of heat from the heating element which generates heat of 150°C or more.

The thermally conductive member can be formed, for example, by filling the thermally conductive composition into gaps between the heating element and the heat-dissipating element, and curing the composition. The curing may be performed by heating, and preferably, the curing is performed near normal temperature (e.g., about 0 to 40°C, preferably about 15 to 35°C). By curing the composition near normal temperature, the thermally conductive member can be disposed inside the electronic device without adding a thermal history to the electronic parts. When the thermally conductive composition is of a two-pack type, it is preferable that after mixing the first agent and the second agent, the mixture should be filled into gaps between the heating element and the heat-dissipating element, followed by curing.

The thermally conductive member can have any shape, may have a sheet shape, or may be used in another shape. The thermally conductive member can have any thickness, and may gave a thickness of, for example, 0.3 to 5 mm, preferably 0.5 to 4 mm, when used. The thermally conductive member according to the present invention, which has flexibility, can exhibit buffer properties, and can be thus suitably used under an environment where vibration occurs, when the thermally conductive member has a large thickness (e.g., 0.5 mm or more).

Examples

Hereinafter, the present invention will be described in more detail by way of Examples, but the present invention is not limited at all by these examples.

<Hardness of cured product of thermally conductive composition>

The first agent and the second agent were filled into a 50-cc two-pack parallel cartridge (1:1 mixing cartridge "CDA050-01-PP" available from MIXPAC), and were mixed with a static mixer ( static mixer for mixing two packs "MA6.3-12S", the number of elements: 6.3 mm × 12, inner diameter of ejection port: 1.5 mm) to prepare a thermally conductive composition (volume ratio: 1:1, mass ratio: 1:1). To the release-treated surface of a PET film which had undergone a releasing treatment ("SG2" available from PANAC CO., LTD.), the resulting thermally conductive composition was applied such that the sample had a thickness of 2 mm, and another PET film ("SG2" available from PANAC CO., LTD.) was placed on the sample such that the release-treated surface of the another PET film was in contact with the sample, and was fixed by pressing. The resulting sample was left to stand at a temperature of 25°C and a humidity of 50% RH for 24 hours, thus obtaining a sample 1A. The resulting sample 1A was punched out into five sheets of a 30-mm square. The sheets were layered, and on the resultant, the type E hardness was measured. The hardness was used as hardness E1.

A sample 2A was prepared by the same method as above, placed into the inside of a thermostat set at 150°C, and left to stand inside the thermostat for 250 hours. The sample 2A after left to stand for 250 hours was taken out from the thermostat, and was cooled to 25°C. Then, the type E hardness of the sample 2A was measured, and was used as hardness E2. From the obtained hardnesses E1 and E2, E2/E1 was also obtained.

<Weight average molecular weights of component (A) and component (D) >

For the first agent and the second agent containing the component (A) and the component (D) (hereinafter, also referred to as "sample"), the weight average molecular weights of the components were determined, using a high-speed liquid chromatograph (HPLC)-Raman microscope composite system (LC-Raman system: available from SHIMADZU CORPORATION, column: Shodex HK-404L (150 mm×4.6 mmI.D., 3.5 μm)). Specifically, each sample was dissolved in tetrahydrofuran to prepare a 0.2 wt% solution. The solution was filtered with a 0.2 μm filter, and then was used for measurement. GPC measurement was performed at a column temperature of 40°C, tetrahydrofuran was used as an elution, and the flow rate of the column mobile phase was 0.2 mL/min. The injection volume was 10 μL, and the split ratio was 9:1. The spotting time was 20 seconds, and the spotting plate used was Hudson PL-PC-000040-P. Different elution positions eluted according to the molecular weight on the chromatogram, i.e., different elutions having different molecular weights were spotted on the spotting plate, and the Raman spectrum obtained from Raman spectroscopy was verified. Thus, each elution position was identified whether it was of the component (A) or the component (D), and the weight average molecular weight of each component was estimated. In the Raman spectrum, the vinyl group was identified by the peak at 1600 $cm^{-1}$, and the methacryloyl group was identified by the peak at 1640 $cm^{-1}$. Next, based on the mixing ratio of the first agent and the second agent, the weight average molecular weights of the component (A) and the component (D) contained in the thermally conductive composition were estimated.

Although the first agent and the second agent were separately analyzed in the above method, a mixture thereof can be analyzed as above. When the materials can be separated, the weight average molecular weight of each of the

components may be measured.

Materials below were used in Examples and Comparative Examples.

< Organopolysiloxanes >

Organopolysiloxane 1 (component (A)): an organopolysiloxane having a vinyl group at both terminals of the chain (vinyl group content: 0.17 mmol/g, viscosity: 410 mPa·s, weight average molecular weight: 25400)

Organopolysiloxane 2 (component (A) and component (B)): a mixture of an organopolysiloxane having a vinyl group at both terminals of the chain (component (A)) and an organopolysiloxane having three or more hydrosilyl groups (component (B)) (vinyl group content: 0.15 mmol/g, hydrosilyl group content: 0.19 mmol/g, viscosity: 336 mPa·s, weight average molecular weight: 25000, mass ratio (component (A):component (B)) = 90:10)

Organopolysiloxane 3 (component (A)): an organopolysiloxane having a vinyl group at both terminals of the chain (vinyl group content: 0.314 mmol/g, viscosity: 100 mPa·s, weight average molecular weight: 11300)

(In the organopolysiloxanes 2, the component (A) does not have a hydrosilyl group, and the component (B) does not have a vinyl group (alkenyl group).)

Organopolysiloxane 4 (component (B)): an organopolysiloxane having a hydrosilyl group at both terminals of the chain (hydrosilyl group content: 0.329 mmol/g, viscosity: 128 mPa·s, weight average molecular weight: 6000)

Organopolysiloxane 5 (component (D)): an organopolysiloxane having a methacryloyl group at one terminal of the chain (methacryloyl group content: 0.20 mmol/g, viscosity: 65 mPa·s, weight average molecular weight: 5000)

Organopolysiloxane 6 (component (D)): an organopolysiloxane having a methacryloyl group at one terminal of the chain (methacryloyl group content: 0.10 mmol/g, viscosity: 177 mPa·s, weight average molecular weight: 10000)

Organopolysiloxane 7: a mixture (vinyl group content: 0.22 mmol/g, viscosity: 110 mPa·s, weight average molecular weight: 5000) of an organopolysiloxane having a vinyl group at one terminal of the chain (component (A), 50 mass%), an organopolysiloxane having a vinyl group at both terminals of the chain (component (A), 25 mass%), and an organopolysiloxane having no vinyl group (component (F), 25 mass%)

Organopolysiloxane 8 (component (F-1)): dimethyl silicone oil having no hydrosilylation addition reactive group (viscosity: 101 mPa·s)

Organopolysiloxane 9 (component (F-2)): an organopolysiloxane not having a hydrosilylation addition reactive group, and having a trialkoxysilyl group at terminals (viscosity: 26 mPa·s)

Organopolysiloxane 10 (component (A)): an organopolysiloxane having a vinyl group at both terminals of the chain (vinyl group content: 0.34 mmol/g, viscosity: 110 mPa·s, weight average molecular weight: 9200)

Organopolysiloxane 11 (component (A) and component (B)):a mixture (vinyl group content: 0.30 mmol/g, hydrosilyl group content: 0.19 mmol/g, viscosity: 90 mPa·s, weight average molecular weight: 9200, mass ratio (component (A):component (B)) = 90:10) of an organopolysiloxane having a vinyl group at both terminals of the chain (component (A)) and an organopolysiloxane having three or more hydrosilyl groups (component (B))

<Thermally conductive filler>

Aluminum oxide 1 (component (C)): spherical alumina (D50: 0.5 μm)
Aluminum oxide 2 (component (C)): spherical alumina (D50: 3 μm)
Aluminum oxide 3 (component (C)): spherical alumina (D50: 18 μm)
Aluminum oxide 4 (component (C)): spherical alumina (D50: 45 μm)
Aluminum oxide 5 (component (C)): spherical alumina (D50: 70 μm)

<Hydrosilylation catalyst>

Platinum catalyst (component (E))

[Examples 1 to 9, Comparative Examples 1 to 4]

First agents and second agents were prepared according to the formulations shown in Tables 1 to 3 below. For thermally conductive compositions prepared by mixing the first agents and the corresponding second agents, a variety of physical properties were measured and evaluated.

[Table 1]

| | | | Example 1 | | Example 2 | | Example 3 | | Example 4 | | Example 5 | |
|---|---|---|---|---|---|---|---|---|---|---|---|---|
| | | | First agent | Second agent | First agent | Second agent | First agent | Second agent | First agent | Second agent | First agent | Second agent |
| Composition (parts by mass) | Organopolysiloxane 1 (A) | | 45.0 | | 45.0 | | 45.0 | | 45.0 | | 45.0 | |
| | Organopolysiloxane 2 (A, B) | | | 45.0 | | 45.0 | | 45.0 | | 45.0 | | 45.0 |
| | Organopolysiloxane 3 (A) | | 7.0 | 7.0 | 5.3 | 5.3 | 3.5 | 3.5 | 7.0 | 7.0 | 5.3 | 5.3 |
| | Organopolysiloxane 4 (B) | | | 30.0 | | 30.0 | | 30.0 | | 30.0 | | 30.0 |
| | Organopolysiloxane 5 (D) | | 11.0 | 11.0 | 8.3 | 8.3 | 5.5 | 5.5 | | | | |
| | Organopolysiloxane 6 (D) | | | | | | | | 22.0 | 22.0 | 16.5 | 16.5 |
| | Organopolysiloxane 7 (A, F) | | | | | | | | | | | |
| | Organopolysiloxane 8 (F) | | 37.0 | 7.0 | 41.5 | 11.5 | 46.0 | 16.0 | 22.0 | | 33.3 | 3.3 |
| | Organopolysiloxane 9 (F) | | 17.5 | 17.5 | 17.5 | 17.5 | 17.5 | 17.5 | 21.5 | 13.5 | 17.5 | 17.5 |
| | Platinum catalyst (E) | | 0.10 | | 0.10 | | 0.10 | | 0.10 | | 0.10 | |
| | Aluminum oxide 1 (C) | | 228 | 228 | 228 | 228 | 228 | 228 | 228 | 228 | 228 | 228 |
| | Aluminum oxide 2 (C) | | 551 | 551 | 551 | 551 | 551 | 551 | 551 | 551 | 551 | 551 |
| | Aluminum oxide 3 (C) | | 163 | 163 | 163 | 163 | 163 | 163 | 163 | 163 | 163 | 163 |
| | Aluminum oxide 4 (C) | | 305 | 305 | 305 | 305 | 305 | 305 | 305 | 305 | 305 | 305 |
| | Aluminum oxide 5 (C) | | 1096 | 1096 | 1096 | 1096 | 1096 | 1096 | 1096 | 1096 | 1096 | 1096 |
| | Total amount of (C) thermally conductive filler | | 2343 | 2343 | 2343 | 2343 | 2343 | 2343 | 2343 | 2343 | 2343 | 2343 |
| | Total Vi+Me content 1 | mmol/g | 0.10 | 0.09 | 0.09 | 0.09 | 0.08 | 0.08 | 0.10 | 0.09 | 0.09 | 0.09 |
| | Total Vi+Me content 2 | μmol/g | 4.7 | | 4.3 | | 3.8 | | 4.7 | | 4.3 | |
| | Total Me content 1 | mmol/g | 0.019 | 0.019 | 0.014 | 0.014 | 0.009 | 0.009 | 0.019 | 0.019 | 0.014 | 0.014 |
| | Total Me content 2 | μmol/g | 0.9 | | 0.7 | | 0.4 | | 0.9 | | 0.7 | |

(continued)

| | | | Example 1 | | Example 2 | | Example 3 | | Example 4 | | Example 5 | |
|---|---|---|---|---|---|---|---|---|---|---|---|---|
| | | | First agent | Second agent | First agent | Second agent | First agent | Second agent | First agent | Second agent | First agent | Second agent |
| Amount of functional group, content | Hydrosilyl group content 1 | mmol/g | 0 | 0.16 | 0 | 0.16 | 0 | 0.16 | 0 | 0.16 | 0 | 0.16 |
| | Hydrosilyl group content 2 | μmol/g | 3.8 | | 3.8 | | 3.8 | | 3.8 | | 3.8 | |
| | Content ratio H/(Vi+Me) | | 0.80 | | 0.88 | | 0.99 | | 0.80 | | 0.88 | |
| | Content ratio H/Vi | | 0.99 | | 1.05 | | 1.12 | | 0.99 | | 1.05 | |
| | Content ratio (H/Vi)-(H/ (Vi+Me) ) | | 0.19 | | 0.16 | | 0.13 | | 0.19 | | 0.16 | |
| | Hydrosilyl group concentration ratio [b1/(b1+b2)] | | 0.53 | | 0.53 | | 0.53 | | 0.53 | | 0.53 | |
| | DVi content/total Vi+Me content | | 0 | | 0 | | 0 | | 0 | | 0 | |
| | Me content/total Vi+Me content | | 0.19 | | 0.16 | | 0.12 | | 0.19 | | 0.16 | |
| | Total content (mass%) of component (F) (relative to total amount of organopolysiloxanes) | | 34% | | 37% | | 41% | | 24% | | 30% | |
| | Weight average molecular weight of all components (A) (first agent and second agent) | | 23500 | 23000 | 23900 | 23400 | 24400 | 23900 | 23500 | 23000 | 23900 | 23400 |
| | Weight average molecular weight of all components (A) | | 23300 | | 23700 | | 24200 | | 23300 | | 23700 | |
| | Raman intensity p2/p1 | | 3.55 | | 3.55 | | 3.55 | | 3.55 | | 3.55 | |
| | Raman intensity ratio H/(Vi+Me) | | 7.26 | | 8.02 | | 8.96 | | 7.26 | | 8.02 | |
| | Raman intensity ratio H/Vi | | 8.96 | | 9.52 | | 10.15 | | 8.96 | | 9.52 | |
| Physical properties of cured product | E hardness after 24 hours at 25°C (E1) | | 50 | | 57 | | 51 | | 54 | | 58 | |
| | E hardness after 250 hours at 150°C (E2) | | 70 | | 72 | | 73 | | 73 | | 69 | |
| | E2/E1 | | 1.40 | | 1.26 | | 1.43 | | 1.35 | | 1.19 | |

[Table 2]

| | | | Example 6 | | Example 7 | | Example 8 | | Example 9 | |
|---|---|---|---|---|---|---|---|---|---|---|
| | | | First agent | Second agent | First agent | Second agent | First agent | Second agent | First agent | Second agent |
| Composition (parts by mass) | Organopolysiloxane 1 (A) | | 45.0 | | 45.0 | | 45.0 | | 45.0 | |
| | Organopolysiloxane 2 (A, B) | | | 45.0 | | 45.0 | | 45.0 | | 45.0 |
| | Organopolysiloxane 3 (A) | | 3.5 | 3.5 | 5.3 | 5.3 | 5.3 | 5.3 | 5.3 | 5.3 |
| | Organopolysiloxane 4 (B) | | | 30.0 | | 30.0 | | 30.0 | | 30.0 |
| | Organopolysiloxane 5 (D) | | | | 26.4 | 18.0 | 31.4 | 18.0 | 36.4 | 18.0 |
| | Organopolysiloxane 6 (D) | | 11.0 | 11.0 | | | | | | |
| | Organopolysiloxane 7 (A, F) | | | | | | | | | |
| | Organopolysiloxane 8 (F) | | 40.5 | 10.5 | 23.4 | 1.8 | 18.4 | 1.8 | 13.4 | 1.8 |
| | Organopolysiloxane 9 (F) | | 17.5 | 17.5 | 17.5 | 17.5 | 17.5 | 17.5 | 17.5 | 17.5 |
| | Platinum catalyst (E) | | 0.10 | | 0.10 | | 0.10 | | 0.10 | |
| | Aluminum oxide 1 (C) | | 228 | 228 | 228 | 228 | 228 | 228 | 228 | 228 |
| | Aluminum oxide 2 (C) | | 551 | 551 | 551 | 551 | 551 | 551 | 551 | 551 |
| | Aluminum oxide 3 (C) | | 163 | 163 | 163 | 163 | 163 | 163 | 163 | 163 |
| | Aluminum oxide 4 (C) | | 305 | 305 | 305 | 305 | 305 | 305 | 305 | 305 |
| | Aluminum oxide 5 (C) | | 1096 | 1096 | 1096 | 1096 | 1096 | 1096 | 1096 | 1096 |
| | Total amount of (C) thermally conductive filler | | 2343 | 2343 | 2343 | 2343 | 2343 | 2343 | 2343 | 2343 |
| | Total Vi+Me content 1 | mmol/g | 0.08 | 0.08 | 0.12 | 0.10 | 0.13 | 0.10 | 0.14 | 0.10 |
| | Total Vi+Me content 2 | μmol/g | 3.8 | | 5.4 | | 5.6 | | 5.8 | |
| | Total Me content 1 | mmol/g | 0.009 | 0.009 | 0.045 | 0.031 | 0.053 | 0.031 | 0.062 | 0.031 |
| | Total Me content 2 | μmol/g | 0.4 | | 1.8 | | 2.0 | | 2.2 | |
| | Hydrosilyl group content 1 | mmol/g | 0 | 0.16 | 0 | 0.16 | 0 | 0.16 | 0 | 0.16 |
| | Hydrosilyl group content 2 | μmol/g | 3.8 | | 3.8 | | 3.8 | | 3.8 | |
| | Content ratio H/(Vi+Me) | | 0.99 | | 0.70 | | 0.67 | | 0.65 | |

(continued)

| | | Example 6 | | Example 7 | | Example 8 | | Example 9 | |
|---|---|---|---|---|---|---|---|---|---|
| | | First agent | Second agent | First agent | Second agent | First agent | Second agent | First agent | Second agent |
| Amount of functional group, content | Content ratio H/Vi | 1.12 | | 1.05 | | 1.05 | | 1.05 | |
| | Content ratio (H/Vi)-(H/(Vi+Me)) | 0.13 | | 0.35 | | 0.38 | | 0.40 | |
| | Hydrosilyl group concentration ratio [b1/(b1+b2)] | 0.53 | | 0.53 | | 0.53 | | 0.53 | |
| | DVi content/total Vi+Me content | 0 | | 0 | | 0 | | 0 | |
| | Me content/total Vi+Me content | 0.12 | | 0.33 | | 0.36 | | 0.38 | |
| | Total content (mass%) of component (F) (relative to total amount of organopolysiloxanes) | 37% | | 26% | | 23% | | 21% | |
| | Weight average molecular weight of all components (A) (first agent and second agent) | 24400 | 23900 | 23900 | 23400 | 23900 | 23400 | 23900 | 23400 |
| | Weight average molecular weight of all components (A) | 24200 | | 23700 | | 23700 | | 23700 | |
| | Raman intensity p2/p1 | 3.55 | | 3.55 | | 3.55 | | 3.55 | |
| | Raman intensity ratio H/(Vi+Me) | 8.96 | | 6.34 | | 6.11 | | 5.90 | |
| | Raman intensity ratio H/Vi | 10.15 | | 9.52 | | 9.52 | | 9.52 | |
| Physical properties of cured product | E hardness after 24 hours at 25°C (E1) | 55 | | 52 | | 50 | | 51 | |
| | E hardness after 250 hours at 150°C (E2) | 68 | | 72 | | 68 | | 69 | |
| | E2/E1 | 1.24 | | 1.38 | | 1.36 | | 1.35 | |

[Table 3]

| | | | Comparative Example 1 | | Comparative Example 2 | | Comparative Example 3 | | Comparative Example 4 | |
|---|---|---|---|---|---|---|---|---|---|---|
| | | | First agent | Second agent | First agent | Second agent | First agent | Second agent | First agent | Second agent |
| Composition (parts by mass) | Organopolysiloxane 1 (A) | | 45.0 | | 45.0 | | 45.0 | | | |
| | Organopolysiloxane 2 (A, B) | | | 45.0 | | 45.0 | | 45.0 | | |
| | Organopolysiloxane 3 (A) | | | | | | | | 5.3 | 5.3 |
| | Organopolysiloxane 4 (B) | | | 30.0 | | 30.0 | | 30.0 | | 30.0 |
| | Organopolysiloxane 5 (D) | | | | | | | | | |
| | Organopolysiloxane 6 (D) | | | | | | | | 16.5 | 16.5 |
| | Organopolysiloxane 7 (A, F) | | 20.0 | 20.0 | 15.0 | 15.0 | 10.0 | 10.0 | | |
| | Organopolysiloxane 8 (F) | | 35.0 | 5.0 | 40.0 | 10.0 | 45.0 | 15.0 | 33.3 | 3.3 |
| | Organopolysiloxane 9 (F) | | 17.5 | 17.5 | 17.5 | 17.5 | 17.5 | 17.5 | 17.5 | 17.5 |
| | Organopolysiloxane 10 (A) | | | | | | | | 45.0 | |
| | Organopolysiloxane 11 (A, B) | | | | | | | | | 45.0 |
| | Platinum catalyst (E) | | 0.10 | | 0.10 | | 0.10 | | 0.10 | |
| | Aluminum oxide 1 (C) | | 228 | 228 | 228 | 228 | 228 | 228 | 228 | 228 |
| | Aluminum oxide 2 (C) | | 551 | 551 | 551 | 551 | 551 | 551 | 551 | 551 |
| | Aluminum oxide 3 (C) | | 163 | 163 | 163 | 163 | 163 | 163 | 163 | 163 |
| | Aluminum oxide 4 (C) | | 305 | 305 | 305 | 305 | 305 | 305 | 305 | 305 |
| | Aluminum oxide 5 (C) | | 1096 | 1096 | 1096 | 1096 | 1096 | 1096 | 1096 | 1096 |
| | Total amount of (C) thermally conductive filler | | 2343 | 2343 | 2343 | 2343 | 2343 | 2343 | 2343 | 2343 |
| | Total Vi+Me content 1 | mmol/g | 0.10 | 0.09 | 0.09 | 0.09 | 0.08 | 0.08 | 0.16 | 0.14 |
| | Total Vi+Me content 2 | μmol/g | 4.7 | | 4.3 | | 3.8 | | 7.2 | |
| | Total Me content 1 | mmol/g | 0 | 0 | 0 | 0 | 0 | 0 | 0.014 | 0.014 |
| | Total Me content 2 | μmol/g | 0 | | 0 | | 0 | | 0.7 | |

(continued)

| | | | Comparative Example 1 | | Comparative Example 2 | | Comparative Example 3 | | Comparative Example 4 | |
|---|---|---|---|---|---|---|---|---|---|---|
| | | | First agent | Second agent | First agent | Second agent | First agent | Second agent | First agent | Second agent |
| Amount of functional group, content | Hydrosilyl group content 1 | mmol/g | 0 | 0.16 | 0 | 0.16 | 0 | 0.16 | 0 | 0.16 |
| | Hydrosilyl group content 2 | μmol/g | 3.8 | | 3.8 | | 3.8 | | 3.8 | |
| | Content ratio H/(Vi+Me) | | 0.80 | | 0.88 | | 0.99 | | 0.52 | |
| | Content ratio H/Vi | | 0.80 | | 0.88 | | 0.99 | | 0.58 | |
| | Content ratio (H/Vi)-(H/ (Vi+Me) ) | | 0 | | 0 | | 0 | | 0.06 | |
| | Hydrosilyl group concentration ratio [b1/(b1+b2)] | | 0.53 | | 0.53 | | 0.53 | | 0.53 | |
| | DVi content/total Vi+Me content | | 0.19 | | 0.16 | | 0.12 | | 0.00 | |
| | Me content/total Vi+Me content | | 0 | | 0 | | 0 | | 0.09 | |
| | Total content (mass%) of component (F) (relative to total amount of organopolysiloxanes) | | 32% | | 36% | | 40% | | 30% | |
| | Weight average molecular weight of all components (A) (first agent and second agent) | | 21700 | 25000 | 22500 | 25000 | 23400 | 25000 | 9200 | 9200 |
| | Weight average molecular weight of all components (A) | | 25200 | | 25200 | | 25200 | | 9200 | |
| | Raman intensity p2/p1 | | 3.55 | | 3.55 | | 3.55 | | 4.05 | |
| | Raman intensity ratio H/(Vi+Me) | | 7.26 | | 8.02 | | 8.96 | | 3.04 | |
| | Raman intensity ratio H/Vi | | 7.26 | | 8.02 | | 8.96 | | 3.73 | |

(continued)

| | | Comparative Example 1 | | Comparative Example 2 | | Comparative Example 3 | | Comparative Example 4 | |
|---|---|---|---|---|---|---|---|---|---|
| | | First agent | Second agent | First agent | Second agent | First agent | Second agent | First agent | Second agent |
| Physical properties of cured product | E hardness after 24 hours at 25°C (E1) | Uncured | | 14 | | 45 | | 55 | |
| | E hardness after 250 hours at 150°C (E2) | Uncured | | 52 | | 71 | | 85 | |
| | E2/E1 | - | | 3.71 | | 1.58 | | 1.55 | |

* The total Vi +Me content 1 indicates the total content of the alkenyl group and the methacryloyl group relative to the total amount of the organopolysiloxanes 1 to 9 in the first agent and the second agent.
* The total Vi+Me content 2 indicates the total content of the alkenyl group and the methacryloyl group relative to the total amount of the thermally conductive composition (first agent and second agent).
* The total Me content 1 indicates the total content of the methacryloyl group relative to the total amount of the organopolysiloxanes 1 to 9 in each of the first agent and the second agent.
* The total Me content 2 indicates the total content of the methacryloyl group relative to the total amount of the thermally conductive composition (first agent and second agent).
* The hydrosilyl group content 1 indicates the total content of the hydrosilyl group relative to the total amount of the organopolysiloxanes 1 to 9 in each of the first agent and the second agent.
* The hydrosilyl group content 2 indicates the total content of the hydrosilyl group relative to the total amount of the thermally conductive composition (the first agent and the second agent).

As clearly shown in Examples above, in the thermal conductive members formed from the thermally conductive compositions satisfying the requirements of the present invention, an increase in hardness was suppressed even when these are placed under a high temperature environment.

In contrast, the thermal conductive members formed from the thermally conductive compositions in Comparative Examples 2 and 3 both did not contain the component (D), and an increase in hardness was not suppressed under a high temperature environment. The thermally conductive composition in Comparative Example 1 was not curable, thus the thermal conductive member thereof was not formed, and the suppression of an increase in hardness was not evaluated. Furthermore, in Comparative Example 4, in which the weight average molecular weight $M_{wd}$ of the component (D) was larger than the weight average molecular weight $M_{wa}$ of the component (A), an increase in hardness was not suppressed under a high temperature environment.

## Claims

1. A thermally conductive composition comprising:

    (A) an organopolysiloxane having an alkenyl group;
    (B) an organo-hydrogen polysiloxane having a hydrosilyl group;
    (C) a thermally conductive filler;
    (D) a polysiloxane compound having a methacryloyl group; and
    (E) a hydrosilylation catalyst,

    a weight average molecular weight of the component (D), $M_{wd}$, being smaller than a weight average molecular weight of the component (A), $M_{wa}$.

2. A thermally conductive composition comprising:

    (A) organopolysiloxane having an alkenyl group;
    (B) an organo-hydrogen polysiloxane having a hydrosilyl group;
    (C) a thermally conductive filler;
    (D) a polysiloxane compound having a methacryloyl group; and
    (E) a hydrosilylation catalyst,

    the thermally conductive composition being a combination of:

    a first agent containing at least one of the component (A) or the component (D); and the component (E) but not containing the component (B), and
    a second agent containing the component (B) but not containing the component (E),
    the component (C) being contained in at least one of the first agent or the second agent, and
    a weight average molecular weight of the component (D), $M_{wd}$, being smaller than a weight average molecular weight of the component (A), $M_{wa}$.

3. The thermally conductive composition according to claim 1 or 2, wherein a weight average molecular weight of the component (D), $M_{wd}$, and a weight average molecular weight of the component (A), $M_{wa}$, satisfy Expression (1) below:

$$M_{wd} \times 2.3 \leq M_{wa} \quad ...(1)$$

4. The thermally conductive composition according to claim 1 or 2, wherein a methacryloyl group content (Me content) and an alkenyl group content (Vi content), each mole-based, satisfy Expressions (2) and (3) below:

$$0.10 \leq \alpha \leq 0.60 \quad ...(2)$$

$$\alpha = \text{Me content}/(\text{Me content} + \text{Vi content}) \quad ...(3).$$

5. The thermally conductive composition according to claim 1 or 2, wherein a content of the hydrosilyl group, H, and a content of an alkenyl group, Vi, each mole-based, satisfy Expression (4) below:

$$0.8 \leq H/Vi \leq 1.5 \ ...(4).$$

6. The thermally conductive composition according to claim 1 or 2, wherein the content of the hydrosilyl group, H, the content of an alkenyl group, Vi, and the content of a methacryloyl group, Me, each mole-based, satisfy Expression (5) below:

$$0.4 \leq H/(Vi+Me) \leq 1.2 \ ...(5).$$

7. The thermally conductive composition according to claim 1 or 2, wherein a type E hardness after the thermally conductive composition is left to stand at 25°C for 24 hours (E1) and a type E hardness after the thermally conductive composition is left to stand at 25°C for 24 hours and further at 150°C for 250 hours (E2) satisfy the relation represented by Expression (6) below:

$$E2/E1 \leq 1.5 \ ...(6).$$

8. The thermally conductive composition according to claim 1 or 2, further comprising (F) an organopolysiloxane having no addition reactive group.

9. The thermally conductive composition according to claim 1 or 2, wherein the viscosity at a temperature of 25°C and a shear rate of 3.16 (1/s) is 10 to 1000 Pa·s.

10. The thermally conductive composition according to claim 1 or 2, wherein the component (C) contains aluminum oxide.

11. A first agent usable as a thermally conductive composition by mixing with a second agent, the thermally conductive composition comprising:

(A) an organopolysiloxane having an alkenyl group;
(B) an organo-hydrogen polysiloxane having a hydrosilyl group;
(C) a thermally conductive filler;
(D) a polysiloxane compound having a methacryloyl group; and
(E) a hydrosilylation catalyst,
the first agent containing at least one of the component (A) or the component (D); and the component (E) but not containing the component (B), and
in a case where the first agent is combined with the second agent, a weight average molecular weight of the component (D), $M_{wd}$, is smaller than a weight average molecular weight of the component (A), $M_{wa}$.

12. A second agent usable as a thermally conductive composition by mixing with a first agent, the thermally conductive composition comprising:

(A) an organopolysiloxane having an alkenyl group;
(B) an organo-hydrogen polysiloxane having a hydrosilyl group;
(C) a thermally conductive filler;
(D) a polysiloxane compound having a methacryloyl group; and
(E) a hydrosilylation catalyst,
the second agent containing the component (B) but not containing the component (E), and
in a case where the second agent is combined with the first agent, a weight average molecular weight of the component (D), $M_{wd}$, is smaller than a weight average molecular weight of the component (A), $M_{wa}$.

13. A thermal conductive member which is a cured product of the thermally conductive composition according to claim 1 or 2.

14. An electrical component wherein a thermal conductive member which is a cured product of the thermally conductive composition according to claim 1 or 2 is interposed between a heating element and a heat-dissipating element.

15. The electrical component according to claim 14, wherein the heating element is disposed at least in an engine room or near a motor.

16. The electrical component according to claim 14 or 15, wherein the electrical component is exposed to an environment at 150°C or more.

## INTERNATIONAL SEARCH REPORT

International application No.
**PCT/JP2023/022400**

**A. CLASSIFICATION OF SUBJECT MATTER**

***C09K 5/14***(2006.01)i; ***C08L 83/04***(2006.01)i; ***C08L 83/05***(2006.01)i; ***C08L 83/07***(2006.01)i
FI: C09K5/14 E; C08L83/04; C08L83/05; C08L83/07

According to International Patent Classification (IPC) or to both national classification and IPC

**B. FIELDS SEARCHED**

Minimum documentation searched (classification system followed by classification symbols)

C09K5/14; C08L83/04; C08L83/05; C08L83/07

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/075434 A1 (DOW TORAY CO., LTD.) 14 April 2022 (2022-04-14) claims 1-7 | 1-16 |
| A | WO 2020/080256 A1 (DENKA COMPANY LIMITED) 23 April 2020 (2020-04-23) claims 1-5 | 1-16 |
| A | WO 2019/021826 A1 (DOW CORNING TORAY CO., LTD.) 31 January 2019 (2019-01-31) claims 1-16 | 1-16 |
| A | JP 2016-513151 A (DOW CORNING CORPORATION) 12 May 2016 (2016-05-12) claims 1-20 | 1-16 |
| A | JP 2009-256428 A (SHIN ETSU CHEM CO LTD) 05 November 2009 (2009-11-05) claims 1-4 | 1-16 |
| A | JP 2008-160126 A (SHIN ETSU CHEM CO LTD) 10 July 2008 (2008-07-10) claims 1-5 | 1-16 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 July 2023** | **08 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/022400**

| Patent document cited in search report | Publication date (day/month/year) | Patent family member(s) | Publication date (day/month/year) |
|---|---|---|---|
| WO 2022/075434 A1 | 14 April 2022 | TW 202227588 A | |
| WO 2020/080256 A1 | 23 April 2020 | US 2021/0407885 A1<br>claims 1-5<br>EP 3868835 A1<br>CN 112805336 A<br>TW 202028312 A | |
| WO 2019/021826 A1 | 31 January 2019 | US 2020/0270499 A1<br>claims 1-13<br>EP 3660100 A1<br>KR 10-2020-0032709 A<br>CN 111051434 A<br>TW 201908413 A | |
| JP 2016-513151 A | 12 May 2016 | WO 2014/124378 A1<br>claims 1-20<br>US 2016/0032060 A1<br>EP 2954024 A1<br>TW 201500469 A<br>CN 104968751 A<br>KR 10-2015-0117268 A | |
| JP 2009-256428 A | 05 November 2009 | (Family: none) | |
| JP 2008-160126 A | 10 July 2008 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2021140694 A